# EUROPEAN PATENT APPLICATION

(11) **EP 4 284 145 A1**
(43) Date of publication of application: **29.11.2023**
(21) Application number: 23174681.9
(22) Date of filing: 22.05.2023
(51) Int. Cl.: H10K 59/40, G06F 3/041, G06F 3/044, H10K 59/126

(54) **DISPLAY DEVICE**

(30) Priority: 23.05.2022 KR 20220062732
(71) Applicant: Samsung Display Co., Ltd., Yongin-si, Gyeonggi-do (KR)
(72) Inventor: SONG, Hyun-gue, Yongin-si (KR); KIM, Youngtae, Yongin-si (KR); JUNG, Hyunho, Yongin-si (KR); JEONG, Heeseong, Yongin-si (KR); JOO, Sunjin, Yongin-si (KR); HONG, Sang Min, Yongin-si (KR)
(74) Representative: Marks & Clerk LLP

(57) **Abstract**

A display device includes an input sensing electrode. A sensing electrode partially shields a first color light emitting area and a second color light emitting area or partially shields a third color light emitting area when the first color light emitting area, the second color light emitting area, and the third color light emitting area are viewed from a first point having a first viewing angle with respect to a normal line of a base layer of the display device.

## Description

### TECHNICAL FIELD

Embodiments of the present disclosure relate to a display device. More particularly, embodiments of the present disclosure relate to a display device including an input sensing electrode.

### DISCUSSION OF RELATED ART

Electronic devices, such as smartphones, tablet computers, notebook computers, car navigation units, and smart televisions, are being developed. Such electronic devices typically include a display device that provides information. Such electronic devices further typically include various electronic modules in addition to the display device.

The display device may be designed to satisfy display quality characteristics for each of various purposes of use. For example, a light generated from a light emitting device of the display device may be emitted to outside of the display device (outside of the electronic device) while generating various optical phenomena such as resonance and interference. These optical phenomena may affect the quality of displayed images.

### SUMMARY

Embodiments of the present disclosure provide a display device having increased display quality.

Embodiments of the present disclosure provide a display device including a base layer, a pixel definition layer disposed on the base layer and including a first light emitting opening, a second light emitting opening, and a third light emitting opening, which are defined therethrough. The display device further includes a first light emitting element including a first electrode providing a first color light emitting area exposed through the first light emitting opening, a second light emitting element including a second electrode providing a second color light emitting area exposed through the second light emitting opening, a third light emitting element including a third electrode providing a third color light emitting area exposed through the third light emitting opening, a thin film encapsulation layer covering the first light emitting element, the second light emitting element, and the third light emitting element, and a sensing electrode disposed on the thin film encapsulation layer and overlapping the pixel definition layer. A first opening corresponding to the first light emitting opening and having a size greater than a size of the first light emitting opening, a second opening corresponding to the second light emitting opening and having a size greater than a size of the second light emitting opening, and a third opening corresponding to the third light emitting opening and having a size greater than a size of the third light emitting opening are defined through the sensing electrode. The sensing electrode partially shields the first color light emitting area and the second color light emitting area or partially shields the third color light emitting area when the first color light emitting area, the second color light emitting area, and the third color light emitting area are viewed from a first point having a first viewing angle with respect to a normal line of the base layer.

In an embodiment, the sensing electrode partially shields the first color light emitting area and the second color light emitting area, and about 5% to about 20% of the first color light emitting area is shielded by the sensing electrode when the first viewing angle is 60°.

In an embodiment, a distance between a plane defined by an upper surface of the first electrode and a plane defined by a lower surface of the sensing electrode is within a range from about 6 micrometers to about 25 micrometers.

In an embodiment, a size of the first color light emitting area shielded by the sensing electrode when the first color light emitting area is viewed from a second point having a same viewing angle as the first point and an azimuth angle different from the first point is different from a size of the first color light emitting area shielded by the sensing electrode when the first color light emitting area is viewed from the first point.

In an embodiment, the sensing electrode partially shields the first color light emitting area and the second color light emitting area, and a size of the first color light emitting area shielded by the sensing electrode is different from a size of the second color light emitting area shielded by the sensing electrode.

In an embodiment, the first color light emitting area and the second color light emitting area have different sizes and different shapes when viewed in a plane.

In an embodiment, a size of the first color light emitting area shielded by the sensing electrode is about equal to a size of the second color light emitting area shielded by the sensing electrode.

In an embodiment, a distance in a plane between the first color light emitting area and the sensing electrode, which is measured at an azimuth angle of the first point, is different from a distance between the second color light emitting area and the sensing electrode, which is measured at the azimuth angle of the first point.

In an embodiment, the first color light emitting area, the second color light emitting area, and the third color light emitting area are not shielded by the sensing electrode when the first color light emitting area, the second color light emitting area, and the third color light emitting areas area are viewed from a second point having a second viewing angle smaller than the first viewing angle.

In an embodiment, the sensing electrode partially shields the first color light emitting area and the second color light emitting area, the first light emitting opening defines an N-sided polygon shape, the first opening defines an M-sided polygon shape, a circular shape, or an oval shape, N is a natural number equal to or greater than 4, M is a natural number greater than N, the second light emitting opening defines an I-sided polygon shape, the second opening defines a J-sided polygon shape, a circular shape, or an oval shape, I is a natural number equal to or greater than 4, and J is a natural number greater than I.

In an embodiment, the third light emitting opening and the third opening define a K-sided polygon shape, K is a natural number equal to or greater than 4, and K is a natural number smaller than M and J.

In an embodiment, the sensing electrode partially shields the third color light emitting area, the third color light emitting area defines a K-sided polygon shape, the third opening defines an L-sided polygon shape, a circular shape, or an oval shape, K is a natural number equal to or greater than 4, and L is a natural number greater than K.

In an embodiment, the first light emitting opening and the first opening define an N-sided polygon shape, the second light emitting opening and the second opening define an I-sided polygon shape, I is a natural number, and N and I is a natural number smaller than L.

In an embodiment, the sensing electrode partially shields the first color light emitting area and the second color light emitting area, distances between the sensing electrode and each of the first color light emitting area and the third color light emitting area, which are respectively measured at azimuth angles of about 0°, about 45°, about 90°, about 135°, about 180°, about 225°, about 270°, and about 315°, are defined as a first distance, a second distance, a third distance, a fourth distance, a fifth distance, a sixth distance, a seventh distance, and an eighth distance, respectively, and each of the first to eighth distances between the sensing electrode and the first color light emitting area is smaller than a corresponding distance among the first to eighth distances between the sensing electrode and the third color light emitting area.

In an embodiment, a difference between the first to eighth distances between the sensing electrode and the first color light emitting area is smaller than a difference between the first to eighth distances between the sensing electrode and the third color light emitting area.

In an embodiment, the difference between the first to eighth distances between the sensing electrode and the first color light emitting area is equal to or smaller than about 1.5 micrometers.

In an embodiment, the second color light emitting area includes a first type light emitting area and a second type light emitting area symmetrical with the first type light emitting area with respect to an imaginary line defined between the azimuth angle of about 90° and the azimuth angle of about 270°.

In an embodiment, the first light emitting element emits a red light, the second light emitting element emits a green light, and the third light emitting element emits a blue light.

Embodiments of the present disclosure provide a display device including a display panel and an input sensor disposed on the display panel. The display panel includes a base layer, a pixel definition layer disposed on the base layer and including a first light emitting opening, a second light emitting opening, and a third light emitting opening, which are defined therethrough, a first light emitting element including a first electrode providing a first color light emitting area exposed through the first light emitting opening, a second light emitting element including a second electrode providing a second color light emitting area exposed through the second light emitting opening, and a third light emitting element including a third electrode providing a third color light emitting area exposed through the third light emitting opening. The input sensor includes a sensing electrode including a first opening corresponding to the first light emitting opening, a second opening corresponding to the second light emitting opening, and a third opening corresponding to the third light emitting opening, which are defined therethrough, and overlapping the pixel definition layer, distances between the sensing electrode and each of the first color light emitting area, the second color light emitting area, and the third color light emitting area which are respectively measured at azimuth angles of about 0°, about 45°, about 90°, about 135°, about 180°, about 225°, about 270°, and about 315° are defined as a first distance, a second distance, a third distance, a fourth distance, a fifth distance, a sixth distance, a seventh distance, and an eighth distance, respectively, and each of the first to eighth distances between the sensing electrode and the first color light emitting area is smaller than a corresponding distance among the first to eighth distances between the sensing electrode and the third color light emitting area.

In an embodiment, each of the first to eighth distances between the sensing electrode and the second color light emitting area is smaller than a corresponding distance among the first to eighth distances between the sensing electrode and the third color light emitting area.

In an embodiment, the second color light emitting area includes a first type light emitting area and a second type light emitting area symmetrical with the first type light emitting area with respect to an imaginary line defined between the azimuth angle of about 90° and the azimuth angle of about 270°.

In an embodiment, a difference between the first to eighth distances between the sensing electrode and the first color light emitting area is smaller than a difference between the first to eighth distances between the sensing electrode and the third color light emitting area.

In an embodiment, the difference between the first to eighth distances between the sensing electrode and the first color light emitting area is equal to or smaller than about 1.5 micrometers.

At least some of the above and other features of the invention are set out in the claims.

According to embodiments of the present disclosure, a variation in wavelength of a white image, which may cause the white image to be perceived differently depending on a viewing angle, may be reduced. As a result, the display quality of the display device may be increased.

In addition, according to embodiments of the present disclosure, a luminance difference of a source light generated according to the azimuth angle may be reduced.

### BRIEF DESCRIPTION OF THE DRAWINGS

The above and other features of the present disclosure will become more apparent by describing in detail embodiments thereof with reference to the accompanying drawings, in which:
FIG. 1 is a perspective view of a display device according to an embodiment of the present disclosure;
FIG. 2 is a cross-sectional view of a display device according to an embodiment of the present disclosure;
FIG. 3A is an enlarged plan view of a display area of a display panel according to an embodiment of the present disclosure;
FIG. 3B is a cross-sectional view of a display device according to an embodiment of the present disclosure;
FIG. 3C is a plan view of an input sensor according to an embodiment of the present disclosure;
FIGS. 4A and 4B are views of a spherical coordinate system defined in a display device.
FIGS. 5A and 5B are views of color coordinate changes of a white image of a display device according to comparative examples;
FIG. 6 is an enlarged plan view of an area of FIG. 3C according to an embodiment of the present disclosure;
FIG. 7A is a plan view of a first color light emitting area and a sensing electrode according to an embodiment of the present disclosure;
FIG. 7B is a cross-sectional view of a radiation path of a first color light according to an embodiment of the present disclosure;
FIG. 7C is a plan view of a second color light emitting area and a sensing electrode according to an embodiment of the present disclosure;
FIG. 7D is a cross-sectional view of a radiation path of a second color light according to an embodiment of the present disclosure;
FIG. 7E is a plan view of a third color light emitting area and a sensing electrode according to an embodiment of the present disclosure;
FIG. 7F is a cross-sectional view of a radiation path of a third color light according to an embodiment of the present disclosure;
FIG. 8 is a view of color coordinate changes of a white image according to an embodiment of the present disclosure;
FIG. 9A is a plan view of a first color light emitting area and a sensing electrode according to an embodiment of the present disclosure;
FIG. 9B is a graph of variations in luminance ratio of a first color light as a function of a viewing angle and an azimuth angle according to an embodiment of the present disclosure;
FIG. 9C is a plan view of a first color light emitting area and a sensing electrode according to a comparative example;
FIG. 9D is a graph of variations in luminance ratio of a first color light as a function of a viewing angle and an azimuth angle according to a comparative example;
FIG. 9E is a plan view of a first type second color light emitting area and a sensing electrode according to an embodiment of the present disclosure;
FIG. 9F is a plan view of a second type second color light emitting area and a sensing electrode according to an embodiment of the present disclosure;
FIG. 10 is an enlarged plan view of a display device according to an embodiment of the present disclosure;
FIG. 11 is an enlarged plan view of a display device according to an embodiment of the present disclosure; and
FIG. 12 is an enlarged plan view of a display device according to an embodiment of the present disclosure.

### DETAILED DESCRIPTION

Embodiments of the present disclosure will be described more fully hereinafter with reference to the accompanying drawings. Like reference numerals may refer to like elements throughout the accompanying drawings.

In the present disclosure, it will be understood that when an element (or area, layer, or portion) is referred to as being "on", "connected to" or "coupled to" another element or layer, it can be directly on, connected or coupled to the other element or layer or intervening elements or layers may be present. It will also be understood that when an element is referred to as being "between" two elements, it can be the only element between the two elements, or one or more intervening elements may also be present. It will also be understood that when an element is referred to as "covering" another element, it can be the only element covering the other element, or one or more intervening elements may also be covering the other element. Other words used to describe the relationships between elements should be interpreted in a like fashion.

As used herein, the term "and/or" may include any and all combinations of one or more of the associated listed items.

It will be understood that, although the terms "first", "second", etc. may be used herein to describe various elements, these elements should not be limited by these terms. These terms are only used to distinguish one element from another element. Thus, a "first" element discussed below could be termed a "second" element without departing from the teachings of the present disclosure.

As used herein, the singular forms, "a", "an" and "the" are intended to include the plural forms as well, unless the context clearly indicates otherwise.

Spatially relative terms, such as "beneath", "below", "lower", "above", "upper" and the like, may be used herein for ease of description to describe one element or feature's relationship to another element or feature as shown in the figures.

It will be further understood that the terms "include" and/or "including", when used in this specification, specify the presence of stated features, integers, steps, operations, elements, and/or components, but do not preclude the presence or addition of one or more other features, integers, steps, operations, elements, components, and/or groups thereof.

Herein, when two or more elements or values are described as being substantially the same as or about equal to each other, it is to be understood that the elements or values are identical to each other, the elements or values are equal to each other within a measurement error, or if measurably unequal, are close enough in value to be functionally equal to each other as would be understood by a person having ordinary skill in the art. For example, the term "about" as used herein is inclusive of the stated value and means within an acceptable range of deviation for the particular value as determined by one of ordinary skill in the art, considering the measurement in question and the error associated with measurement of the particular quantity (e.g., the limitations of the measurement system). For example, "about" may mean within one or more standard deviations as understood by one of the ordinary skill in the art. Further, it is to be understood that while parameters may be described herein as having "about" a certain value, according to exemplary embodiments, the parameter may be exactly the certain value or approximately the certain value within a measurement error as would be understood by a person having ordinary skill in the art.

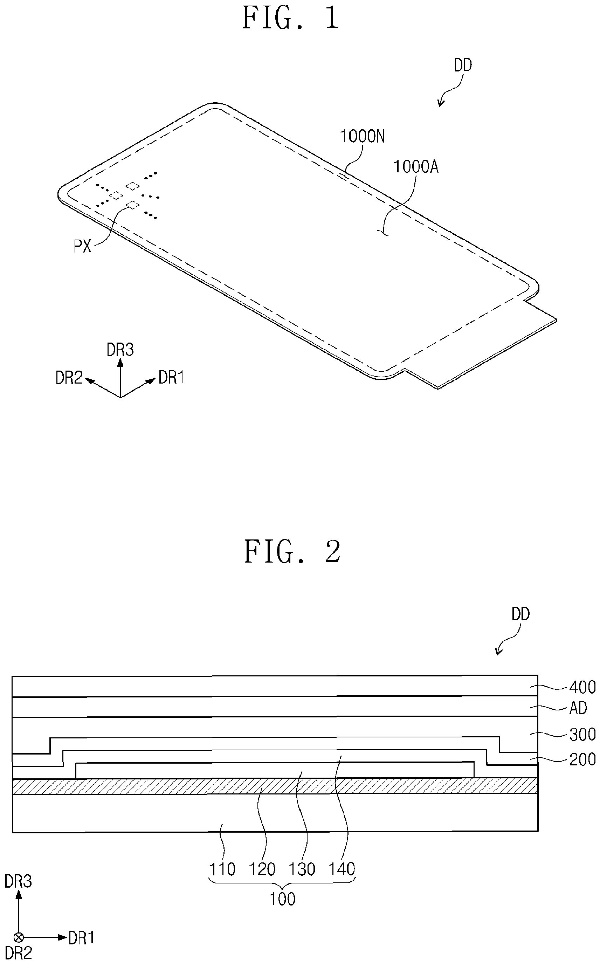

FIG. 1 is a perspective view of a display device DD according to an embodiment of the present disclosure.

The display device DD may generate an image and may sense an external input. The display device DD may include a display area 1000A and a peripheral area 1000N. A plurality of pixels PX may be disposed in the display area 1000A. The pixels PX may include, for example, a first color pixel, a second color pixel, and a third color pixel, which generate light having different colors from each other.

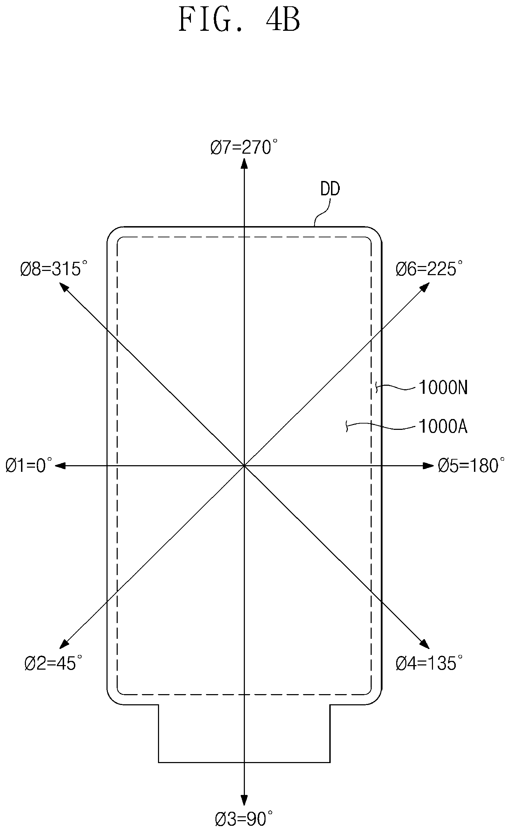

The image may be displayed through the display area 1000A. The display area 1000A may include a plane defined by a first direction DR1 and a second direction DR2. The first direction DR1 may be a direction connecting an azimuth angle of about 0° and an azimuth angle of about 180° described with reference to FIG. 4B, and the second direction DR2 may be a direction connecting an azimuth angle of about 90° and an azimuth angle of about 270° described with reference to FIG. 4B. The display area 1000A may further include curved surfaces bent from at least two sides of the plane. However, the shape of the display area 1000A is not limited thereto. For example, the display area 1000A may include only the plane, or the display area 1000A may further include two or more curved surfaces, e.g., four curved surfaces respectively bent from four sides of the plane. The display device DD may be, for example, a foldable display device or a rollable display device.

FIG. 2 is a cross-sectional view of the display device DD according to an embodiment of the present disclosure. Referring to FIG. 2, the display device DD may include a display panel 100, an input sensor 200, an anti-reflector 300, and a window 400.

The display panel 100 may be a light emitting type display panel. For example, the display panel 100 may include a base layer 110, a driving element layer 120, a light emitting element layer 130, and a thin film encapsulation layer 140.

The base layer 110 may provide a base surface on which the driving element layer 120 is disposed. The base layer 110 may be a rigid substrate or a flexible substrate that is bendable, foldable, or rollable. The base layer 110 may be, for example, a glass substrate, a metal substrate, or a polymer substrate. However, the base layer 110 is not limited thereto. According to an embodiment, the base layer 110 may be, for example, an inorganic layer, an organic layer, or a composite material layer.

The base layer 110 may have a multi-layer structure. For example, the base layer 110 may include a first synthetic resin layer, an inorganic layer having a single-layer or multi-layer structure, and a second synthetic resin layer disposed on the inorganic layer having the single-layer or multi-layer structure. Each of the first and second synthetic resin layers may include a polyimide-based resin, however, embodiments are not limited thereto.

The driving element layer 120 may be disposed on the base layer 110. The driving element layer 120 may include, for example, an insulating layer, a semiconductor pattern, a conductive pattern, and a signal line. The driving element layer 120 may further include a driving circuit for the pixels PX described with reference to FIG. 1.

The light emitting element layer 130 may be disposed on the driving element layer 120. The light emitting element layer 130 may include a light emitting element for the pixels PX described with reference to FIG. 1. For example, the light emitting element may include an organic light emitting material, an inorganic light emitting material, an organic-inorganic light emitting material, a quantum dot, a quantum rod, a micro-LED, or a nano-LED.

The thin film encapsulation layer 140 may be disposed on the light emitting element layer 130. The thin film encapsulation layer 140 may protect the light emitting element layer 130 from, for example, moisture, oxygen, and a foreign substance such as dust particles. The thin film encapsulation layer 140 may include at least one inorganic layer. The thin film encapsulation layer 140 may include a stack structure in which an inorganic layer, an organic layer, and an inorganic layer are sequentially stacked.

The input sensor 200 may be disposed on the display panel 100. The input sensor 200 may sense an external input applied thereto from outside of the display device DD. For example, the external input may include a variety of external inputs, such as a part of user's body, light, heat, pen, or pressure.

The input sensor 200 may be formed on the display panel 100 through successive processes. In this case, the input sensor 200 may be disposed directly on the display panel 100. In the present disclosure, the expression "component A is disposed directly on component B" means that no intervening components are present between component A and component B. For example, in an embodiment in which the input sensor 200 is disposed directly on the display panel 100, an adhesive layer is not disposed between the input sensor 200 and the display panel 100.

The anti-reflector 300 may reduce a reflectance with respect to an external light. The anti-reflector 300 may be disposed directly on the input sensor 200. The anti-reflector 300 may include color filters. For example, the anti-reflector 300 may include a first color filter, a second color filter, and a third color filter, which are disposed to respectively correspond to or overlap the first color pixel, the second color pixel, and the third color pixel. The anti-reflector 300 may further include a black matrix. The black matrix may be disposed between the first color filter, the second color filter, and the third color filter. The black matrix may define a boundary between the first color filter, the second color filter, and the third color filter.

However, embodiments of the present disclosure are not limited thereto. For example, in an embodiment, the anti-reflector 300 may be coupled with the input sensor 200 by an adhesive layer. The anti-reflector 300 may include an optical film. The optical film may include a polarizing film. The optical film may further include a retarder film. The retarder film may include at least one of a λ/2 retarder film and a λ/4 retarder film.

The window 400 may be disposed on the anti-reflector 300. The window 400 and the anti-reflector 300 may be coupled with each other by an adhesive layer AD. The adhesive layer AD may be, for example, a pressure sensitive adhesive (PSA) film or an optically clear adhesive (OCA).

The window 400 may include at least one base layer. The base layer may be a glass substrate or a synthetic resin film. The window 400 may have a multi-layer structure. The window 400 may include a thin film glass substrate and a synthetic resin film disposed on the thin film glass substrate. The thin film glass substrate and the synthetic resin film may be coupled with each other by an adhesive layer, and the adhesive layer and the synthetic resin film may be separated from the thin film glass substrate to be replaced.

According to an embodiment, the adhesive layer AD may be omitted, and the window 400 may be disposed directly on the anti-reflector 300. An organic material, an inorganic material, or a ceramic material may be coated on the anti-reflector 300.

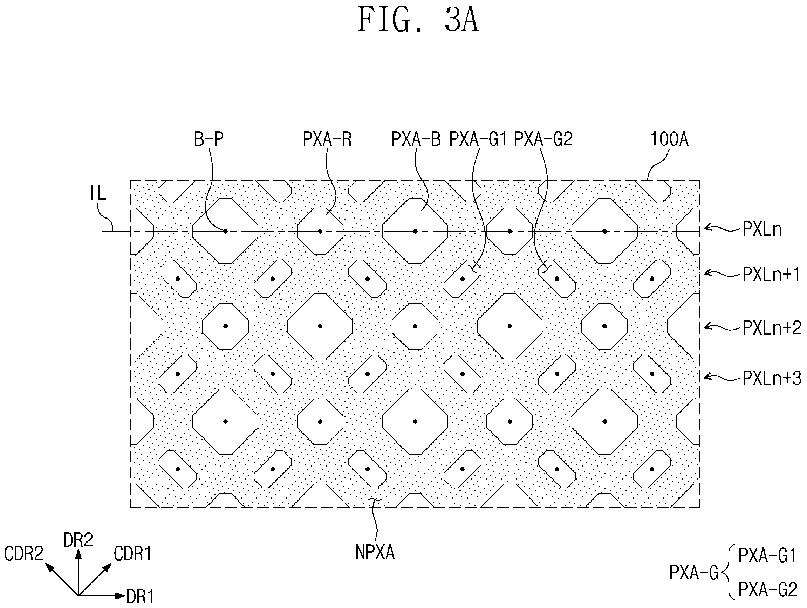

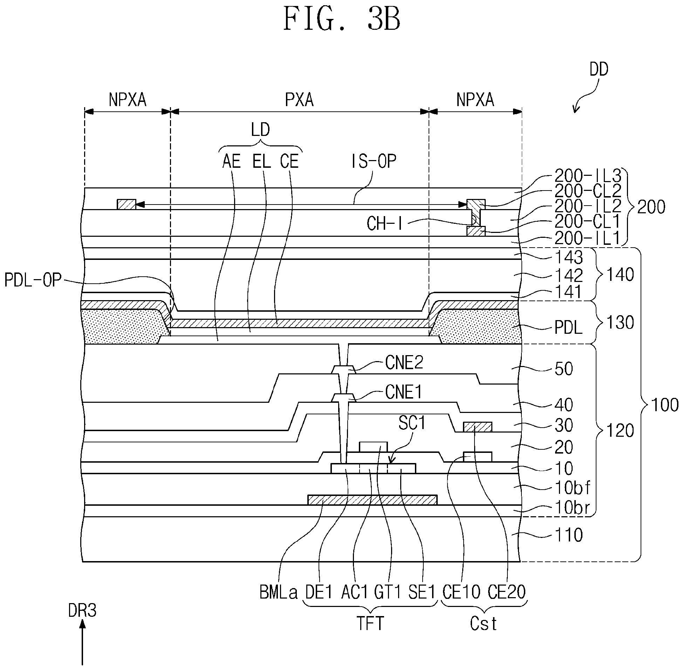

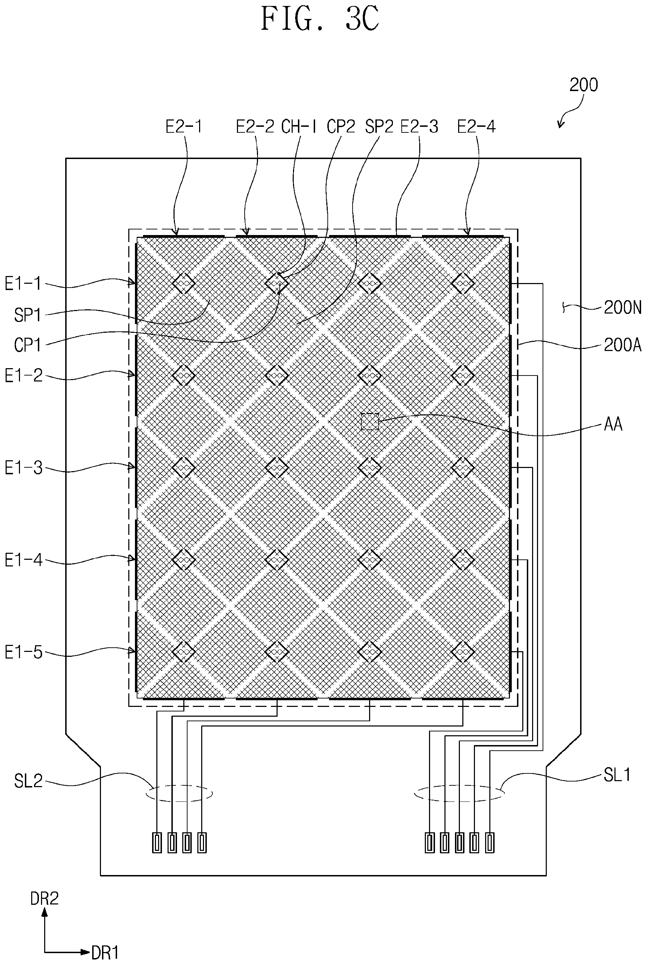

FIG. 3A is an enlarged plan view of a display area 100A of the display panel 100 (refer to FIG. 2) according to an embodiment of the present disclosure. FIG. 3B is a cross-sectional view of the display device DD according to an embodiment of the present disclosure. FIG. 3C is a plan view of the input sensor 200 according to an embodiment of the present disclosure.

Referring to FIG. 3A, the display area 100A may include a plurality of light emitting areas PXA-R, PXA-G, and PXA-B and a non-light-emitting area NPXA defined between the light emitting areas PXA-R, PXA-G, and PXA-B. The light emitting areas PXA-R, PXA-G, and PXA-B may be grouped into three groups of the light emitting areas PXA-B, PXA-R, and PXA-G. The three groups of the light emitting areas PXA-B, PXA-R, and PXA-G may be distinguished from each other according to a color of a source light generated by the light emitting element LD (refer to FIG. 3B).

In an embodiment, the first color light emitting area PXA-R may provide a red light, the second color light emitting area PXA-G may provide a green light, and the third color light emitting area PXA-B may provide a blue light. According to an embodiment, the display panel 100 may include three groups of light emitting areas respectively displaying three primary colors of yellow, magenta, and cyan.

The first color light emitting area PXA-R, the second color light emitting area PXA-G, and the third color light emitting area PXA-B may have different sizes from each other. However, embodiments of the present disclosure are not limited thereto. According to an embodiment, the first color light emitting area PXA-R, the second color light emitting area PXA-G, and the third color light emitting area PXA-B may have substantially the same size as each other.

Each of the first color light emitting area PXA-R, the second color light emitting area PXA-G, and the third color light emitting area PXA-B may have a substantially polygonal shape. In an embodiment, the term "substantially polygonal shape" as used herein may include a polygonal shape in a mathematical meaning, a polygonal shape whose vertices are curved, or a polygonal shape whose vertices are not angular, e.g., rounded. The shape of the light emitting area may be the same as a light emitting opening PDL-OP (refer to FIG. 3B) defined through a pixel definition layer PDL (refer to FIG. 3B). However, the shape of vertices may vary depending on an etching characteristics of the pixel definition layer PDL.

In an embodiment, each of the first color light emitting area PXA-R and the third color light emitting area PXA-B may have an octagonal shape symmetrical with respect to each of the first direction DR1 and the second direction DR2. In addition, the second color light emitting area PXA-G may have an octagonal shape asymmetrical with respect to each of the first direction DR1 and the second direction DR2. The second color light emitting area PXA-G may be symmetrical with respect to a first oblique direction CDR1 crossing the first direction DR1 and the second direction DR2 and may be symmetrical with respect to a second oblique direction CDR2 substantially perpendicular to the first oblique direction CDR1.

The second color light emitting area PXA-G may include a first type second color light emitting area PXA-G1 (hereinafter, referred to as a first type light emitting area) symmetrical with a second type second color light emitting area PXA-G2 (hereinafter, referred to as a second type light emitting area) with respect to the second direction DR2. According to an embodiment, the second color light emitting area PXA-G may include only the first type light emitting area PXA-G1 or the second type light emitting area PXA-G2. According to an embodiment, the second color light emitting area PXA-G may include a light emitting area symmetrical with respect to each of the first direction DR1 and the second direction DR2.

According to an embodiment, each of the first color light emitting area PXA-R and the third color light emitting area PXA-B may have a square shape symmetrical with respect to each of the first direction DR1 and the second direction DR2. According to an embodiment, the second color light emitting area PXA-G may have a substantially rectangular shape. The first type light emitting area PXA-G1 and the second type light emitting area PXA-G2 may have the substantially rectangular shape symmetrical with respect to the second direction DR2.

Referring to FIG. 3A, the light emitting areas PXA-B, PXA-R, and PXA-G may define a plurality of light emitting rows arranged in the second direction DR2. The light emitting rows may include an n-th (n is a natural number) light emitting row PXLn, an (n+1)th light emitting row PXLn+1, an (n+2)th light emitting row PXI,n+2, and an (n+3)th light emitting row PXLn+3. The four light emitting rows PXLn, PXLn+1, PXI,n+2, and PXLn+3 may form a group and may be repeatedly arranged in the second direction DR2. Each of the four light emitting rows PXLn, PXLn+1, PXI,n+2, and PXLn+3 may extend in the first direction DR1.

The n-th light emitting row PXLn may include the first color light emitting areas PXA-R and the third color light emitting areas PXA-B alternately arranged with the first color light emitting areas PXA-R in the first direction DR1. The (n+2)th light emitting row PXLn+2 may include the third color light emitting areas PXA-B and the first color light emitting areas PXA-R alternately arranged with the third color light emitting areas PXA-B in the first direction DR1.

An arrangement order of the light emitting areas in the n-th light emitting row PXLn may be different from an arrangement order of the light emitting areas in the (n+2)th light emitting row PXI,n+2. The third color light emitting areas PXA-B and the first color light emitting areas PXA-R of the n-th light emitting row PXLn may be arranged in a staggered manner with respect to the third color light emitting areas PXA-B and the first color light emitting areas PXA-R of the (n+2)th light emitting row PXI,n+2. The first color light emitting areas PXA-R of the n-th light emitting row PXLn may be shifted to the first direction DR1 by one light emitting area when compared to the first color light emitting areas PXA-R of the (n+2)th light emitting row PXI,n+2, and the third color light emitting area PXA-B of the n-th light emitting row PXLn may be shifted to the first direction DR1 by one light emitting area when compared to the third color light emitting area PXA-B of the (n+2)th light emitting row PXLn+2.

The second color light emitting areas PXA-G may be disposed in each of the (n+1)th light emitting row PXI,n+1 and the (n+3)th light emitting row PXLn+3. The (n+1)th light emitting row PXI,n+1 may include the second type light emitting areas PXA-G2 and the first type light emitting areas PXA-G1, which are alternately arranged with each other in the first direction DR1. The (n+3)th light emitting row PXLn+3 may include the first type light emitting areas PXA-G1 and the second type light emitting areas PXA-G2, which are alternately arranged with each other in the first direction DR1.

The light emitting areas of the n-th light emitting row PXLn may be arranged in a staggered manner with respect to the light emitting areas of the (n+1)th light emitting row PXI,n+1. The light emitting areas of the (n+2)th light emitting row PXLn+2 may be arranged in a staggered manner with respect to the light emitting areas of the (n+3)th light emitting row PXLn+3. Center points B-P of the light emitting areas disposed in each of the four light emitting rows PXLn, PXLn+1, PXI,n+2, and PXLn+3 may be arranged on the same imaginary line IL.

As the light emitting areas PXA-R, PXA-G, and PXA-B are arranged as described above, four second color light emitting areas PXA-G may be disposed around one first color light emitting area PXA-R. In addition, two second color light emitting areas PXA-G may face each other with the first color light emitting area PXA-R interposed therebetween in the first oblique direction CDR1, and the other two second color light emitting areas PXA-G may face each other with the first color light emitting area PXA-R interposed therebetween in the second oblique direction CDR2. In addition, four second color light emitting areas PXA-G may be disposed around one third color light emitting area PXA-B. In addition, two second color light emitting areas PXA-G may face each other with the third color light emitting area PXA-B interposed therebetween in the first oblique direction CDR1, and the other two second color light emitting areas PXA-G may face each other with the third color light emitting area PXA-B interposed therebetween in the second oblique direction CDR2.

FIG. 3B shows a cross-section of the display device DD corresponding to one light emitting area PXA and the non-light-emitting area NPXA disposed around the light emitting area PXA. For example, FIG. 3B shows a cross-section of the display panel 100 and the input sensor 200. The light emitting area PXA of FIG. 3B may be one of the light emitting areas PXA-B, PXA-R, and PXA-G of FIG. 3A.

The display panel 100 is illustrated mainly focusing on the light emitting element LD and a transistor TFT connected to the light emitting element LD. The transistor TFT may be one of a plurality of transistors included in the driving circuit of the pixels PX (refer to FIG. 1). In an embodiment, the transistor TFT will be described as a silicon transistor, however, the transistor TFT is not limited thereto. For example, according to an embodiment, the transistor TFT may be a metal oxide transistor.

A barrier layer 10br may be disposed on the base layer 110. The barrier layer 10br may prevent a foreign substance from entering thereinto from outside of the display device DD. The barrier layer 10br may include at least one inorganic layer. The barrier layer 10br may include a silicon oxide layer and a silicon nitride layer. Each of the silicon oxide layer and the silicon nitride layer may be provided in plural, and the silicon oxide layers and the silicon nitride layers may be alternately stacked with each other.

A shielding electrode BMLa may be disposed on the barrier layer 10br. The shielding electrode BMLa may include a metal material. The shielding electrode BMLa may include, for example, molybdenum (Mo), an alloy including molybdenum (Mo), titanium (Ti), or an alloy including titanium (Ti), which has a good heat resistance. The shielding electrode BMLa may receive a bias voltage.

The shielding electrode BMLa may prevent an electric potential caused by a polarization phenomenon from exerting influence on the transistor TFT. The shielding electrode BMLa may prevent an external light from reaching the transistor TFT. According to an embodiment, the shielding electrode BMLa may be a floating electrode isolated from other electrodes or lines.

A buffer layer 10bf may be disposed on the barrier layer 10br. The buffer layer 10bf may prevent metal atoms or impurities from being diffused to a semiconductor pattern SC1 disposed thereon from the base layer 110. The buffer layer 10bf may include at least one inorganic layer. The buffer layer 10bf may include a silicon oxide layer and a silicon nitride layer.

The semiconductor pattern SC1 may be disposed on the buffer layer 10bf. The semiconductor pattern SC1 may include a silicon semiconductor. As an example, the silicon semiconductor may include amorphous silicon or polycrystalline silicon. For example, the semiconductor pattern SC1 may include low temperature polycrystalline silicon.

The semiconductor pattern may include a first region having a relatively high conductivity and a second region having a relatively low conductivity. The first region may be doped with an N-type dopant or a P-type dopant. A P-type transistor may include a doped region doped with the P-type dopant, and an N-type transistor may include a doped region doped with the N-type dopant. The second region may be a non-doped region or a region doped at a concentration lower than that of the first region.

The first region may have a conductivity greater than that of the second region and may substantially serve as an electrode or a signal line. The second region may substantially correspond to an active area (or a channel) of the transistor. In other words, a portion of the semiconductor pattern may be the active area of the transistor, another portion of the semiconductor pattern may be a source or a drain of the transistor, and the other portion of the semiconductor pattern may be a connection electrode or a connection signal line.

A source area SE1 (or a source), an active area AC1 (or a channel), and a drain area DE1 (or a drain) of the transistor TFT may be formed from the semiconductor pattern SC1. The source area SE1 and the drain area DE1 may extend in opposite directions to each other from the active area AC1 in a cross-section.

A first insulating layer 10 may be disposed on the buffer layer 10bf. The first insulating layer 10 may commonly overlap the pixels PX (refer to FIG. 1) and may cover the semiconductor pattern. The first insulating layer 10 may include an inorganic layer and/or an organic layer and may have a single-layer or multi-layer structure. The inorganic layer may include at least one of, for example, aluminium oxide, titanium oxide, silicon oxide, silicon nitride, silicon oxynitride, zirconium oxide, and hafnium oxide. In an embodiment, the first insulating layer 10 may have a single-layer structure of a silicon oxide layer. Not only the first insulating layer 10, but also an insulating layer of the driving element layer 120 described below may include an inorganic layer and/or an organic layer and may have a single-layer or multi-layer structure. The inorganic layer may include at least one of the above-mentioned materials. However, the inorganic layer is not limited thereto.

Agate GT1 of the transistor TFT may be disposed on the first insulating layer 10. The gate GT1 may be a portion of a metal pattern. The gate GT1 may overlap the active area AC1. The gate GT1 may be used as a mask in a process of doping the semiconductor pattern. The gate GT1 may include, for example, titanium (Ti), silver (Ag), an alloy including silver (Ag), molybdenum (Mo), an alloy including molybdenum (Mo), aluminium (Al), an alloy including aluminium (Al), aluminium nitride (AlN), tungsten (W), tungsten nitride (WN), copper (Cu), indium tin oxide (ITO), indium zinc oxide (IZO), or the like, however, the gate GT1 is not particularly limited.

A second insulating layer 20 may be disposed on the first insulating layer 10 and may cover the gate GT1. A third insulating layer 30 may be disposed on the second insulating layer 20. A second electrode CE20 of a storage capacitor Cst may be disposed between the second insulating layer 20 and the third insulating layer 30. In addition, a first electrode CE10 of the storage capacitor Cst may be disposed between the first insulating layer 10 and the second insulating layer 20.

A first connection electrode CNE1 may be disposed on the third insulating layer 30. The first connection electrode CNE1 may be connected to the drain area DE1 of the transistor TFT via a contact hole defined through the first, second, and third insulating layers 10, 20, and 30.

A fourth insulating layer 40 may be disposed on the third insulating layer 30. A second connection electrode CNE2 may be disposed on the fourth insulating layer 40. The second connection electrode CNE2 may be connected to the first connection electrode CNE1 via a contact hole defined through the fourth insulating layer 40. A fifth insulating layer 50 may be disposed on the fourth insulating layer 40 and may cover the second connection electrode CNE2. The stack structure of the first insulating layer 10 to the fifth insulating layer 50 is merely an example according to an embodiment, and additional conductive layer and insulating layer may be disposed in addition to the first insulating layer 10 to the fifth insulating layer 50 according to embodiments.

Each of the fourth insulating layer 40 and the fifth insulating layer 50 may include an organic layer. As an example, the organic layer may include a general-purpose polymer such as benzocyclobutene (BCB), polyimide, hexamethyldisiloxane (HMDSO), polymethylmethacrylate (PMMA), or polystyrene (PS), a polymer derivative having a phenolic group, an acrylic-based polymer, an imide-based polymer, an aryl ether-based polymer, an amide-based polymer, a fluorine-based polymer, a p-xylene-based polymer, a vinyl alcohol-based polymer, or blends thereof.

The light emitting element LD may include a first electrode AE (an anode or a pixel electrode), a light emitting layer EL, and a second electrode CE (a cathode or a common electrode). The first electrode AE may be disposed on the fifth insulating layer 50. The first electrode AE may be connected to the second connection electrode CNE2 via a contact hole defined through the fifth insulating layer 50. However, embodiments of the present disclosure are not limited thereto. According to an embodiment, the second connection electrode CNE2 may be connected to the second electrode CE. In this case, the first electrode AE (or anode) may correspond to the common electrode, and the second electrode CE (or cathode) may be disposed in each of the light emitting areas PXA-B, PXA-R, and PXA-G of FIG. 3A after being divided into a plurality of portions. In addition, even though the light emitting element LD has the structure shown in FIG. 3B, the first electrode AE may be the cathode, and the second electrode CE may be the anode (an inverted structure) according to an embodiment.

The first electrode AE may be a semi-transmissive electrode, a transmissive electrode, or a reflective electrode. According to an embodiment, the first electrode AE may include a reflective layer formed of, for example, Ag, Mg, Al, Pt, Pd, Au, Ni, Nd, Ir, Cr, or compounds thereof, and a transparent or semi-transparent electrode layer formed on the reflective layer. The transparent or semi-transparent electrode layer may include at least one of, for example, indium tin oxide (ITO), indium zinc oxide (IZO), indium gallium zinc oxide (IGZO), zinc oxide (ZnO) or indium oxide (In₂O₃), and aluminium-doped zinc oxide (AZO). For example, the first electrode AE may have a stack structure of ITO/Ag/ITO.

The pixel definition layer PDL may be disposed on the fifth insulating layer 50. The pixel definition layer PDL may be an organic layer. The pixel definition layer PDL may have a light absorbing property. For example, the pixel definition layer PDL may have a black color. The pixel definition layer PDL may include a black coloring agent. The black coloring agent may include a black dye or a black pigment. The black coloring agent may include a carbon black, a metal material, such as chromium, or an oxide thereof. The pixel definition layer PDL may correspond to a light blocking pattern having a light blocking property.

The pixel definition layer PDL may cover a portion of the first electrode AE. As an example, the light emitting opening PDL-OP may be defined through the pixel definition layer PDL to expose a portion of the first electrode AE. The light emitting opening PDL-OP may define the light emitting area PXA of the display panel 100. In addition, the light emitting opening PDL-OP may define the light emitting area of the first electrode AE. The light emitting area of the first electrode AE may be defined as the portion of the first electrode AE exposed without being covered by the pixel definition layer PDL. In an embodiment, the light emitting opening PDL-OP, the light emitting area of the display panel 100, and the light emitting area of the first electrode AE may be defined identically.

A first light emitting opening, a second light emitting opening, and a third light emitting opening may be defined through the pixel definition layer PDL to respectively correspond to the first color light emitting area PXA-R, the second color light emitting area PXA-G, and the third color light emitting area PXA-B described with reference to FIG. 3A.

A hole control layer may be disposed between the first electrode AE and the light emitting layer EL. The hole control layer may include a hole transport layer and may further include a hole injection layer. An electron control layer may be disposed between the light emitting layer EL and the second electrode CE. The electron control layer may include an electron transport layer and may further include an electron injection layer. The hole control layer and the electron control layer may commonly overlap the first color light emitting area PXA-R, the second color light emitting area PXA-G, the third color light emitting area PXA-B, and the non-light-emitting area NPXA described with reference to FIG. 3A.

The thin film encapsulation layer 140 may be disposed on the light emitting element layer 130. The thin film encapsulation layer 140 may include an inorganic layer 141, an organic layer 142, and an inorganic layer 143, which are sequentially stacked. However, layers forming the thin film encapsulation layer 140 are not limited thereto.

The inorganic layers 141 and 143 may protect the light emitting element layer 130 from moisture and oxygen, and the organic layer 142 may protect the light emitting element layer 130 from a foreign substance such as dust particles. The inorganic layers 141 and 143 may include, for example, a silicon nitride layer, a silicon oxynitride layer, a silicon oxide layer, a titanium oxide layer, or an aluminium oxide layer. The organic layer 142 may include an acrylic-based organic layer, however, the organic layer 142 is not limited thereto.

The input sensor 200 may include a first insulating layer 200-IL1 (or a base insulating layer), a first conductive pattern layer 200-CL1, a second insulating layer 200-IL2 (or an intermediate insulating layer), a second conductive pattern layer 200-CL2, and a third insulating layer 200-IL3 (or a cover insulating layer). The first insulating layer 200-IL1 may be disposed directly on the thin film encapsulation layer 140.

According to an embodiment, the first insulating layer 200-IL1 and/or the third insulating layer 200-IL3 may be omitted. When the first insulating layer 200-IL1 is omitted, the first conductive pattern layer 200-CL1 may be disposed directly on an uppermost insulating layer of the thin film encapsulation layer 140. The third insulating layer 200-IL3 may be replaced with an adhesive layer or an insulating layer of an anti-reflector 300 disposed on the input sensor 200. According to an embodiment, the input sensor 200 may include only one of the first conductive pattern layer 200-CL1 and the second conductive pattern layer 200-CL2.

The first conductive pattern layer 200-CL1 may include a first conductive pattern, and the second conductive pattern layer 200-CL2 may include a second conductive pattern. Each of the first conductive pattern and the second conductive pattern may include patterns regularly arranged. Hereinafter, the first conductive pattern layer 200-CL1 and the first conductive pattern are assigned with the same reference numeral, and the second conductive pattern layer 200-CL2 and the second conductive pattern are assigned with the same reference numeral.

Each of the first conductive pattern 200-CL1 and the second conductive pattern 200-CL2 may have a single-layer structure or may have a multi-layer structure of layers stacked along the third direction DR3. The multi-layered conductive pattern may include at least two layers among transparent conductive layers and metal layers. The multi-layered conductive pattern may include the metal layers containing different metal materials from each other. The transparent conductive layer may include, for example, indium tin oxide (ITO), indium zinc oxide (IZO), zinc oxide (ZnO), indium tin zinc oxide (ITZO), PEDOT, a metal nanowire, or graphene. The metal layer may include, for example, molybdenum, silver, titanium, copper, aluminium, and alloys thereof.

The first conductive pattern 200-CL1 and the second conductive pattern 200-CL2 may overlap the non-light-emitting area NPXA. The second conductive pattern 200-CL2 may be provided with an opening IS-OP defined therethrough to correspond to the light emitting area PXA. The opening IS-OP may have a size greater than that of the light emitting area PXA.

In an embodiment, each of the first insulating layer 200-IL1, the second insulating layer 200-IL2, and the third insulating layer 200-IL3 may include an inorganic layer and/or an organic layer. According to an embodiment, the first insulating layer 200-IL1, the second insulating layer 200-IL2, and the third insulating layer 200-IL3 may include the inorganic layer. The inorganic layer may include, for example, silicon oxide, silicon nitride, or silicon oxynitride.

According to an embodiment, at least one of the first insulating layer 200-IL1, the second insulating layer 200-IL2, and the third insulating layer 200-IL3 may include the organic layer. For example, the third insulating layer 200-IL3 may include the organic layer. The organic layer may include at least one of, for example, an acrylic-based resin, a methacrylic-based resin, a polyisoprene-based resin, a vinyl-based resin, an epoxy-based resin, a urethane-based resin, a cellulose-based resin, a siloxane-based resin, a polyimide-based resin, a polyamide-based resin, and a perylene-based resin.

Referring to FIG. 3C, the input sensor 200 may include a sensing area 200A and a non-sensing area 200N disposed adjacent to the sensing area 200A. The sensing area 200A and the non-sensing area 200N may correspond to the display area 1000A and the peripheral area 1000N shown in FIG. 1, respectively.

The input sensor 200 may include first sensing electrodes E1-1 to E1-5 and second sensing electrodes E2-1 to E2-4, which are disposed in sensing area 200A and are insulated from each other while crossing each other. The external input may be sensed by calculating a variation in mutual capacitance formed between the first sensing electrodes E1-1 to E1-5 and the second sensing electrodes E2-1 to E2-4.

A self-capacitance type input sensor 200 may include sensing electrodes that do not cross each other. In an embodiment, it is sufficient that the input sensor 200 includes the sensing electrode, and a driving manner of the input sensor 200 is not particularly limited.

The input sensor 200 may include first signal lines SL1 disposed in the non-sensing area 200N and electrically connected to the first sensing electrodes E1-1 to E1-5 and second signal lines SL2 disposed in the non-sensing area 200N and electrically connected to the second sensing electrodes E2-1 to E2-4. The first sensing electrodes E1-1 to E1-5, the second sensing electrodes E2-1 to E2-4, the first signal lines SL1, and the second signal lines SL2 may be defined by each of the first conductive pattern 200-CL1 and the second conductive pattern 200-CL2 or a combination of the first conductive pattern 200-CL1 and the second conductive pattern 200-CL2, which are described with reference to FIG. 3B.

Each of the first sensing electrodes E1-1 to E1-5 and the second sensing electrodes E2-1 to E2-4 may include a plurality of conductive lines crossing each other. The conductive lines may define a plurality of openings, and each of the first sensing electrodes E1-1 to E1-5 and the second sensing electrodes E2-1 to E2-4 may have a mesh shape. Each of the openings may be defined as the opening IS-OP shown in FIG. 3B.

One of the first sensing electrodes E1-1 to E1-5 and the second sensing electrodes E2-1 to E2-4 may be provided integrally. In an embodiment, the first sensing electrodes E1-1 to E1-5 are integrally provided. The first sensing electrodes E1-1 to E1-5 may include sensing portions SP1 and intermediate portions CP1. A portion of the second conductive pattern 200-CL2 may correspond to the first sensing electrodes E1-1 to E1-5.

Each of the second sensing electrodes E2-1 to E2-4 may include sensing patterns SP2 and bridge patterns CP2 (or connection patterns). Two sensing patterns SP2 disposed adjacent to each other may be connected to two bridge patterns CP2 via a contact hole CH-I defined through the second insulating layer 200-IL2 (refer to FIG. 3B). However, the number of the bridge patterns is not particularly limited. A portion of the second conductive pattern 200-CL2 may correspond to the sensing patterns SP2. A portion of the first conductive pattern 200-CL1 may correspond to the bridge patterns CP2.

In an embodiment, the bridge patterns CP2 may be formed from the first conductive pattern 200-CL1 shown in FIG. 3B, and the first sensing electrodes E1-1 to E1-5 and the sensing patterns SP2 may be formed from the second conductive pattern 200-CL2 shown in FIG. 3B. However, embodiments are not limited thereto. According to an embodiment, the first sensing electrodes E1-1 to E1-5 and the sensing patterns SP2 may be formed from the first conductive pattern 200-CL1 shown in FIG. 3B, and the bridge patterns CP2 may be formed from the second conductive pattern 200-CL2.

One of the first signal lines SL1 and the second signal lines SL2 may transmit a transmission signal to sense an external input from an external circuit, and the other one of the first signal lines SL1 and the second signal lines SL2 may transmit the variation in capacitance between the first sensing electrodes E1-1 to E1-5 and the second sensing electrodes E2-1 to E2-4 to the external circuit as a reception signal.

A portion of the second conductive pattern 200-CL2 may correspond to the first signal lines SL1 and the second signal lines SL2. The first signal lines SL1 and the second signal lines SL2 may have a multi-layer structure and may include a first layer line formed from the first conductive pattern 200-CL1 and a second layer line formed from the second conductive pattern 200-CL2. The first layer line and the second layer line may be connected to each other via a contact hole defined through the second insulating layer 200-IL2 (refer to FIG. 3B).

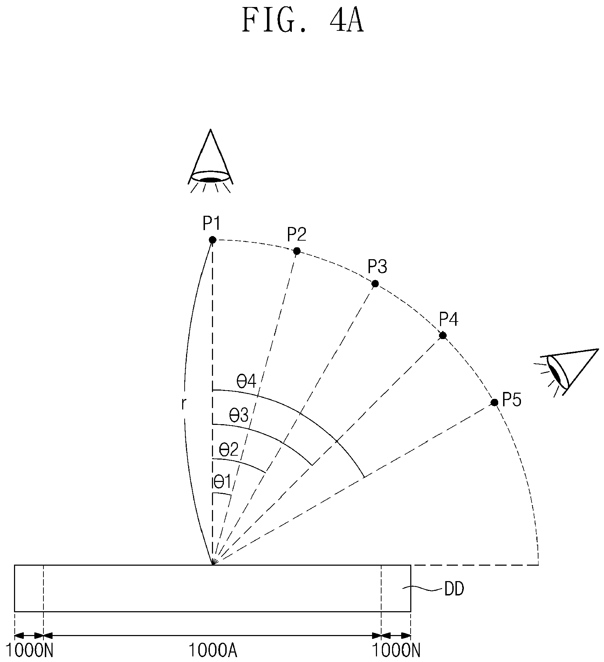

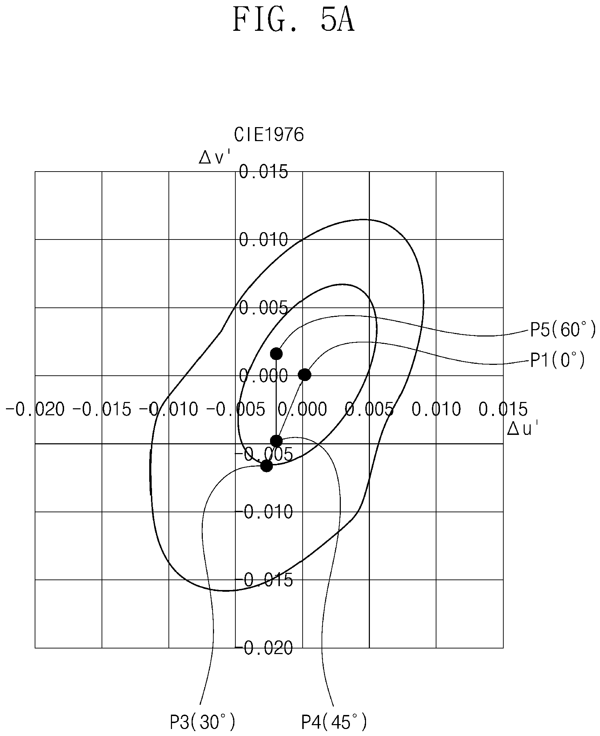

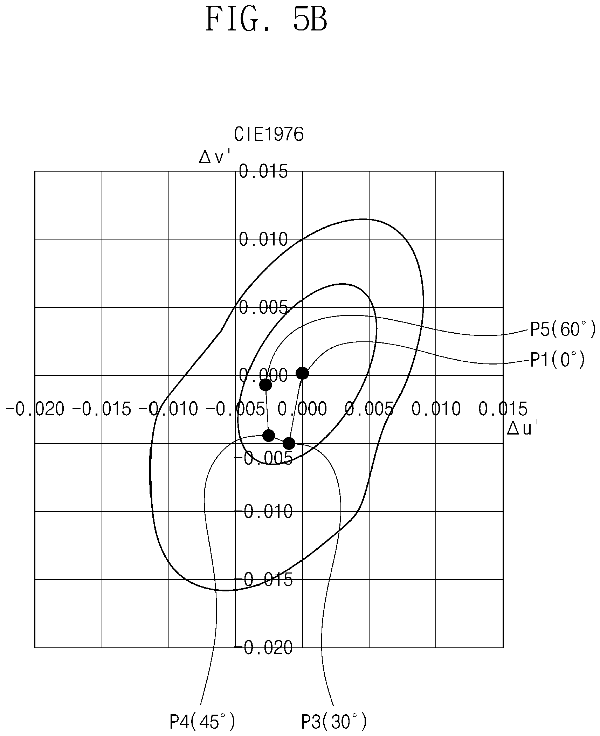

FIGS. 4A and 4B are views of a spherical coordinate system defined in the display device DD. FIGS. 5A and 5B are views of color coordinate changes of a white image of a display device according to comparative examples.

Referring to FIGS. 4A and 4B, the spherical coordinate system may be defined in the display device DD. An origin point of the spherical coordinate system may be aligned with a center of the display area 1000A of the display device DD. The spherical coordinate system may be used to distinguish measurement points to measure a display quality of the display device DD.

The coordinates of the spherical coordinate system may be indicated by r, θ, and Φ, r indicates a distance from the origin point to the measurement point, θ indicates an angle between a z-axis (or a normal axis of the display device DD) and a straight line defined between the origin point and the measurement point, and Φ indicates an angle between an x-axis (or a horizontal axis passing through the center of the display device DD) and a straight line obtained by an orthogonal projection of the straight line defined between the origin point and the measurement point onto an x-y plane (or a front surface of the display device DD). For the convenience of explanation, θ is referred to as a viewing angle, and Φ is referred to as an azimuth angle.

FIG. 4A shows five measurement points P1 to P5. A first viewing angle of the first measurement point P1 may be about 0°. Second, third, fourth, and fifth viewing angles θ1, θ2, θ3, and θ4 may have a predetermined angle from the z-axis (or the normal axis of the display device DD). The second, third, fourth, and fifth viewing angles θ1, θ2, θ3, and θ4 of the second to fifth measurement points P2 to P5 may be about 15°, about 30°, about 45°, and about 60°, respectively. According to an embodiment, the second, third, fourth, and fifth viewing angles θ1, θ2, θ3, and θ4 of the second to fifth measurement points P2 to P5 may be about 20°, about 40°, about 60°, and about 80°, respectively. According to an embodiment, the second, third, fourth, and fifth viewing angles θ1, θ2, θ3, and θ4 of the second to fifth measurement points P2 to P5 may be about 10°, about 20°, about 30°, and about 40°, respectively.

FIG. 4B shows eight azimuth angles Φ1 to Φ8 as a representative example. The eight azimuth angles Φ1 to Φ8 may be about 0°, about 45°, about 90°, about 135°, about 180°, about 225°, about 270°, and about 315°, respectively.

FIGS. 5A and 5B show color coordinate changes Δu' and Δv' according to the viewing angle. The color coordinate changes Δu' and Δv' of FIGS. 5A and 5B are measured at measurement points having the azimuth angle of about 90°. The white image is measured at four measurement points with different viewing angles, and the color coordinates measured at the first measurement point with the viewing angle of about 0° are used as the basis for the color coordinate changes Δu' and Δv'. The color coordinate changes Δu' and Δv' are expressed based on color coordinates u' and v' of CIE1976 color coordinate system.

The four measurement points may correspond to the first measurement point P1, the third measurement point P3, the fourth measurement point P4, and the fifth measurement point P5 of FIG. 4A. The four measurement points may be spaced apart from the origin point at the same distance r (refer to FIG. 4A).

A raw white image may be obtained by mixing light generated by the pixels PX shown in FIG. 1. For example, the white image may be generated by mixing a first color light generated by the first color pixels, a second color light generated by the second color pixels, and a third color light generated by the third color pixels. The first color light may be a red light, the second color light may be a green light, and the third color light may be a blue light.

Referring to the graphs of FIGS. 5A and 5B, although there is a slight difference for each display device, the color coordinate changes Δu' and Δv' of the third measurement point P3 with the viewing angle of about 30° may be similar to those of the fourth measurement point P4 with the viewing angle of about 45°. Referring to the graphs of FIGS. 5A and 5B, the value of Δv' of the color coordinate changes Δu' and Δv' at the fifth measurement point P5 with the viewing angle of about 60° is significantly increased compared to that of the third measurement point P3 and the fourth measurement point P4. This means that the white image measured at the fifth measurement point P5 becomes yellowish compared to the white image measured at the third measurement point P3 and the fourth measurement point P4.

A user may perceive that a white image perceived (or measured) at the fifth measurement point P5 has a color impression different from the white image perceived (or measured) at the third measurement point P3 and the fourth measurement point P4. The user may perceive a yellowish white image at the fifth measurement point P5. When the user perceives that the white image has different color impressions depending on the viewing angle, it means that the display quality is deteriorated. When the white images measured at the measurement points except the first measurement point P1 have similar color impression, the user may become insensitive (or less sensitive) to the color coordinate changes Δu' and Δv' depending on the viewing angle.

In an embodiment, it is assumed that an interference of the sensing electrodes E1-1 to E1-5 and E2-1 to E2-4 of the input sensor 200 (refer to FIGS. 3B and 3C) on a path through which the raw white image radiates to the four measurement points is negligible. The meaning of the expression that the interference of the sensing electrodes of the input sensor on the radiation path is negligible will be described below.

The phenomenon in which the color coordinates changes Δu' and Δv' occur according to the measurement point when compared to the raw white image is called a white wavelength shift or a white angular dependency (WAD). It is assumed that the raw white image is substantially measured at the first measurement point P1. There may be a variety of reasons why the color coordinate changes Δu' and Δv' are generated at the third measurement point P3 to the fifth measurement point P5 compared to the first measurement point P1 and why the value Δv' of the color coordinate changes Δu' and Δv' at the fifth measurement point P5 significantly increase compared to the value of Δv' of the color coordinate changes Δu' and Δv' at each of the third measurement point P3 and the fourth measurement point P4.

One of the reasons may be a light emitting material of the light emitting layer EL (refer to FIG. 3B). Each of the first color light emitting element, the second color light emitting element, and the third color light emitting element may have a light emitting profile determined by the light emitting material. The light emitting element of the display panel showing the graph of FIG. 5A and the light emitting element of the display panel showing the graph of FIG. 5B include different light emitting materials from each other.

For example, although the first color light emitting elements emit the red light, the profile of luminance in the wavelength range of the red light may vary depending on the light emitting material of the light emitting elements. The radiation path may vary depending on the wavelength in the wavelength range of the red light. The radiation path in the wavelength of about 650nm may be slightly different from the radiation path in the wavelength of about 670nm, and the value of Δv' may relatively increase at a viewing angle where a wavelength with a high emission peak is transmitted more.

In the graph of FIG. 5A and the graph of FIG. 5B, as the reason why the value of Δv' of the color coordinate changes Δu' and Δv' at the fifth measurement point P5 is significantly higher than that of the color coordinate changes Δu' and Δv' at the third measurement point P3 and the fourth measurement point P4, it is assumed that the first color light emitting element and the second color light emitting element have the light emitting profile providing more light at the viewing angle of about 60° compared to the third color light emitting element.

According to an embodiment, the sensing electrodes E1-1 to E1-5 and E2-1 to E2-4 (refer to FIG. 3C) may cause the interference on the white image while the white image passes through the input sensor 200. Thus, a difference between the color coordinate changes Δu' and Δv' measured at a high viewing angle and the color coordinate changes Δu' and Δv' measured at a low viewing angle may be reduced. The input sensor 200 may be designed so that the sensing electrodes E1-1 to E1-5 and E2-1 to E2-4 may interfere only with the radiation path of the high viewing angle. In addition, the input sensor 200 may be designed so that the sensing electrodes E1-1 to E1-5 and E2-1 to E2-4 may interfere only with a radiation path of a specific light among the first color light, the second color light, and the third color light. Hereinafter, the principle of how the sensing electrodes E1-1 to E1-5 and E2-1 to E2-4 of the input sensor 200 control an amount of interference on the first color light, the second color light, and the third color light according to the viewing angle will be described.

In an embodiment, it is described that the yellowish white image is perceived by the user at the fifth measurement point P5. However, embodiments of the present disclosure are not limited thereto. The white image measured at the fifth measurement point P5 may be a bluish white image. According to an embodiment, the white image measured at the fifth measurement point P5 may be a magentish white image or a greenish white image. According to an embodiment, the white image measured at the fifth measurement point P5 may be a cyanish white image or a reddish white image.

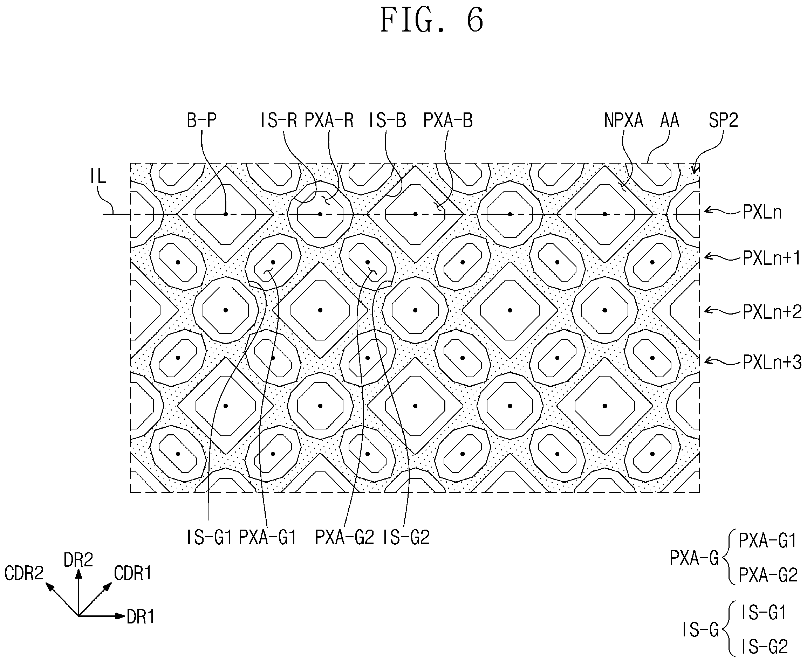

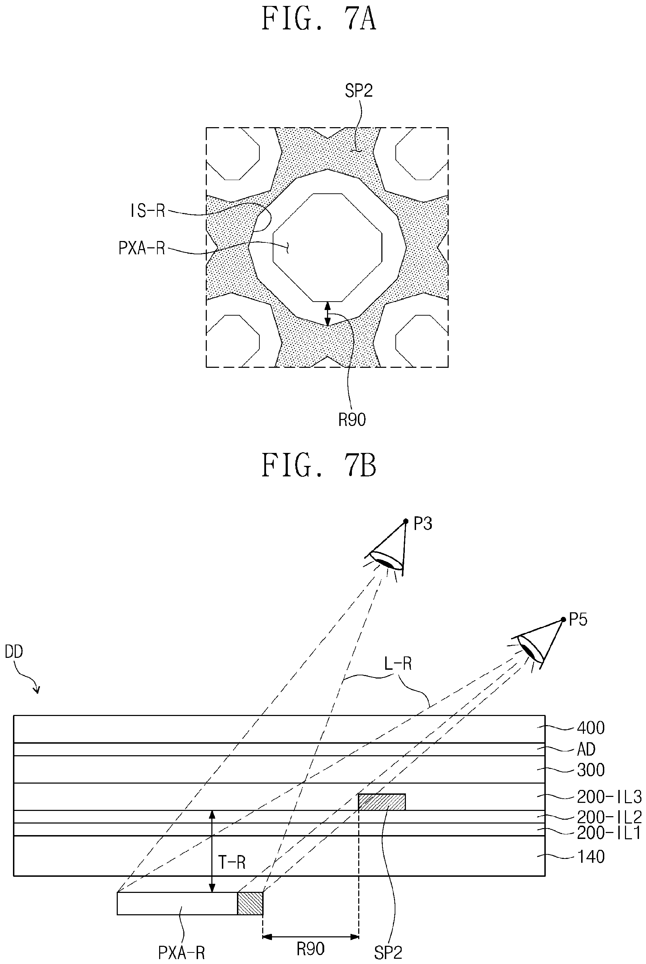

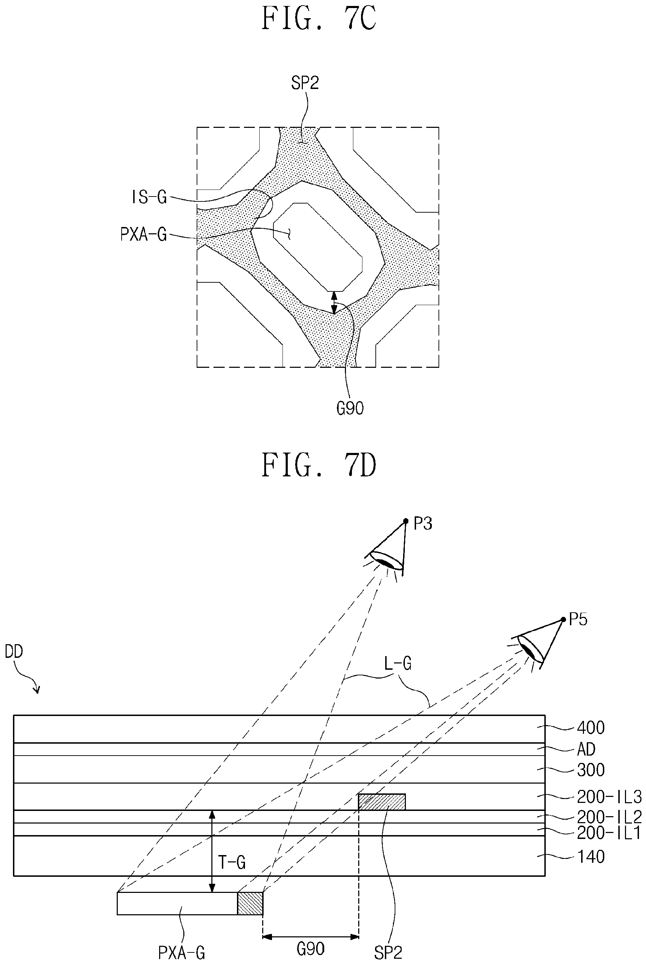

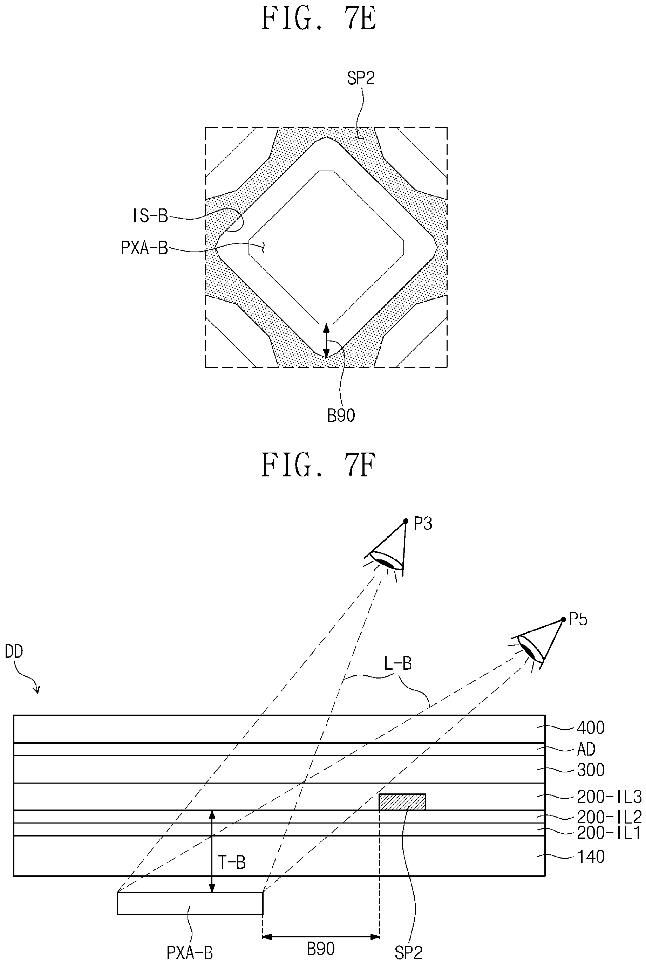

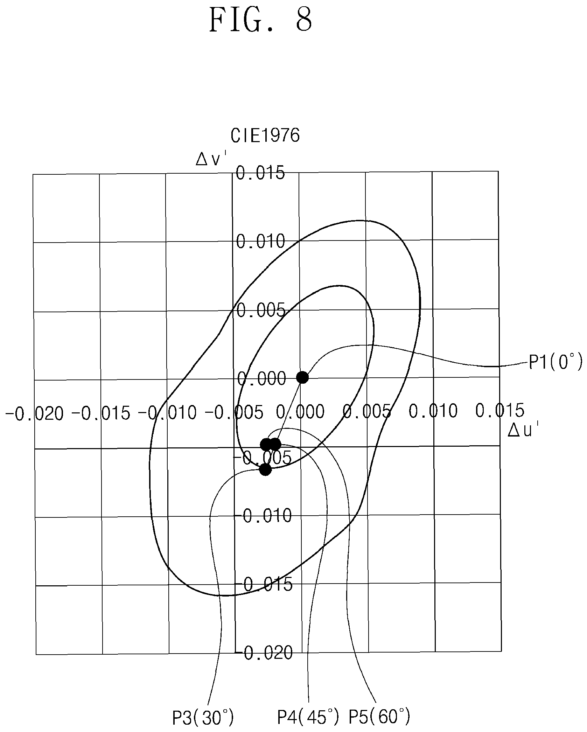

FIG. 6 is an enlarged plan view of an area AA of FIG. 3C according to an embodiment of the present disclosure. FIG. 7A is a plan view of the first color light emitting area PXA-R and the sensing pattern SP2 according to an embodiment of the present disclosure. FIG. 7B is a cross-sectional view of a radiation path of the first color light L-R according to an embodiment of the present disclosure. FIG. 7C is a plan view of the second color light emitting area PXA-G and the sensing pattern SP2 according to an embodiment of the present disclosure. FIG. 7D is a cross-sectional view of a radiation path of the second color light L-G according to an embodiment of the present disclosure. FIG. 7E is a plan view of the third color light emitting area PXA-B and the sensing pattern SP2 according to an embodiment of the present disclosure. FIG. 7F is a cross-sectional view of a radiation path of the third color light L-B according to an embodiment of the present disclosure. FIG. 8 is a view of color coordinate changes of a white image according to an embodiment of the present disclosure.

FIG. 6 is an enlarged plan view of the sensing pattern SP2, and is referred to herein to describe the first sensing electrodes E1-1 to E1-5 and the second sensing electrodes E2-1 to E2-4 having the mesh shape shown in FIG. 3C. The other portions of the first sensing electrodes E1-1 to E1-5 and the second sensing electrodes E2-1 to E2-4, which are not shown in FIG. 6, may have substantially the same shape as the sensing patterns SP2 shown in FIG. 6. Hereinafter, the sensing pattern SP2 will be described as a sensing electrode SP2.

The sensing electrode SP2 may be provided with first, second, and third openings IS-R, IS-G, and IS-B defined therethrough to respectively correspond to the first color, second color, and third color light emitting areas PXA-R, PXA-G, and PXA-B. The second opening IS-G may include first type openings IS-G1 and second type openings IS-G2, which respectively correspond to the first type light emitting areas PXA-G1 and the second type light emitting areas PXA-G2.

Accordingly, the sensing electrode SP2 may have a grid shape or a mesh shape. A conductive line forming the sensing electrode SP2 may have a line width from about 2 micrometers to about 5 micrometers.

According to an embodiment, the distance between each of the first color, second color, and third color light emitting areas PXA-R, PXA-G, and PXA-B and the sensing electrode SP2 at a specific azimuth angle might not be uniform. This is to generate a shielding efficiency by the sensing electrode SP2 only in a specific light emitting area when looking at each of the first color, second color, and third color light emitting areas PXA-R, PXA-G, and PXA-B from a measurement point with a specific azimuth angle and a specific viewing angle.

Referring to FIG. 5A, the white image measured at the fifth measurement point P5 is described as being yellowish compared to the white image measured at the fourth measurement point P4. In an embodiment described herein, however, the display device that includes the first color, second color, and third color light emitting areas PXA-R, PXA-G, and PXA-B and the sensing electrode SP2, which may reduce a yellowish discoloration, will be described as a representative example.

FIGS. 7A, 7C, and 7E are enlarged plan views respectively showing the first color, second color, and third color light emitting areas PXA-R, PXA-G, and PXA-B shown in FIG. 6. In FIGS. 7C and 7D, the second type light emitting area PXA-G2 shown in FIG. 6 is illustrated as the second color light emitting area PXA-G.

Referring to FIGS. 7A to 7F, a distance R90 between the first color light emitting area PXA-R and the sensing electrode SP2 in the plane and a distance G90 between the second color light emitting area PXA-G and the sensing electrode SP2 in the plane may be smaller than a distance B90 between the third color light emitting area PXA-B and the sensing electrode SP2 in the plane. The distances R90, G90, and B90 may respectively indicate separation distances between vertices of the first, second, and third openings IS-R, IS-G, and IS-B and sides of the first color, second color, and third color light emitting areas PXA-R, PXA-G, and PXA-B at the azimuth angle of about 90° when viewed in the plane.

Referring to FIGS. 7A and 7B, the distance R90 between the first color light emitting area PXA-R and the sensing electrode SP2 may be set as a distance where the shielding efficiency due to the sensing electrode SP2 is not generated when looking at the first color light emitting area PXA-R from the third measurement point P3 and the shielding efficiency due to the sensing electrode SP2 is generated when looking at the first color light emitting area PXA-R from the fifth measurement point P5.

As shown in FIG. 7B, when looking at the first color light emitting area PXA-R from the fifth measurement point P5, the first color light emitting area PXA-R may be partially shielded by the sensing electrode SP2. The distance R90 may be set to allow about 5% to about 20% of the first color light emitting area PXA-R to be shielded by the sensing electrode SP2. As a shielding rate increases, an amount of the first color light L-R provided to the fifth measurement point P5 may decrease. This may reduce a value of Δv' measured at the fifth measurement point P5.

The distance R90 that allows the first color light emitting area PXA-R to be partially shielded by the sensing electrode SP2 may be determined according to a distance T-R between a plane defined by the first color light emitting area PXA-R and a plane defined by a lower surface of the sensing electrode SP2, e.g., a distance in a thickness direction of the display device DD. The plane defined by the first color light emitting area PXA-R may be a plane defined by an upper surface of the first electrode AE shown in FIG. 3B. The distance T-R between the first color light emitting area PXA-R and the sensing electrode SP2 in the thickness direction of the display device DD may be within a range from about 6 micrometers to about 25 micrometers. The distance R90 may be changed depending on the distance T-R in the thickness direction, and the distance R90 between the first color light emitting area PXA-R and the sensing electrode SP2 may be equal to or smaller than about 20 micrometers.

In an embodiment, when the distance T-R between the first color light emitting area PXA-R and the sensing electrode SP2 in the thickness direction is about 13 micrometers and the distance R90 between the first color light emitting area PXA-R and the sensing electrode SP2 in the plane is about 5 micrometers, about 10% of the first color light emitting area PXA-R may be shielded by the sensing electrode SP2.

In an embodiment, a shielding area of the first color light emitting area PXA-R due to the sensing electrode SP2 measured at the fifth measurement point P5 is not determined solely by the distance R90 between the first color light emitting area PXA-R and the sensing electrode SP2. The shielding area of the first color light emitting area PXA-R due to the sensing electrode SP2 measured at the fifth measurement point P5 may be determined by distances between the sensing electrode SP2 and the first color light emitting area PXA-R in a range from the azimuth angle of about 0° to the azimuth angle of about 180°. Nevertheless, the distance R90 between the first color light emitting area PXA-R and the sensing electrode SP2 measured at the azimuth angle of about 90° may be a major factor in determining the shielding area of the first color light emitting area PXA-R by the sensing electrode SP2. As shown in FIG. 7A, this is because the first color light emitting area PXA-R is disposed in the first opening IS-R having a polygonal shape when viewed in the plane.

Referring to FIG. 7C, the distance G90 between the second color light emitting area PXA-G and the sensing electrode SP2 in the plane may be set as a distance where the shielding efficiency due to the sensing electrode SP2 is not generated when looking at the second color light emitting area PXA-G from the third measurement point P3 and the shielding efficiency due to the sensing electrode SP2 is generated when looking at the second color light emitting area PXA-G from the fifth measurement point P5. As a shielding rate increases, an amount of the second color light L-G provided to the fifth measurement point P5 may be reduced.

Referring to FIG. 7D, when looking at the second color light emitting area PXA-G from the fifth measurement point P5, the distance G90 may be set to allow about 5% to about 20% of the second color light emitting area PXA-G to be shielded by the sensing electrode SP2. A distance T-G between the second color light emitting area PXA-G and the sensing electrode SP2 may be within a range from about 6 micrometers to about 25 micrometers, and the distance G90 between the second color light emitting area PXA-G and the sensing electrode SP2 may be equal to or smaller than about 20 micrometers.

In an embodiment, when the distance T-G between the second color light emitting area PXA-G and the sensing electrode SP2 in the thickness direction is about 13 micrometers and the distance G90 between the second color light emitting area PXA-G and the sensing electrode SP2 in the plane is about 3 micrometers, about 10% of the second color light emitting area PXA-G may be shielded by the sensing electrode SP2. A reason why the shielding rate of the first color light emitting area PXA-R by the sensing electrode SP2 and the shielding rate of the second color light emitting area PXA-G by the sensing electrode SP2 are similar with each other even though the distance R90 of FIG. 7A and the distance G90 of FIG. 7C are different from each other is because the first color light emitting area PXA-R and the second color light emitting area PXA-G have different shapes and sizes and the first opening IS-R and the second opening IS-G have different shapes and sizes.

When looking at the first color light emitting area PXA-R and the second color light emitting area PXA-G from the fifth measurement point P5, the shielding area (hereinafter, referred to as a first shielding area) of the first color light emitting area PXA-R by the sensing electrode SP2 may be different from the shielding area (hereinafter, referred to as a second shielding area) of the second color light emitting area PXA-G by the sensing electrode SP2. A difference between the first shielding area and the second shielding area may be changed depending on the values of the color coordinate changes Δu' and Δv' measured at the fifth measurement point P5. Due to the first shielding area and the second shielding area, not only the value of Δv' but also the value of Δu' of the color coordinate changes may be changed. In the same manner, the distance R90 between the first color light emitting area PXA-R and the sensing electrode SP2 may be equal to or different from the distance G90 between the second color light emitting area PXA-G and the sensing electrode SP2.

Referring to FIGS. 7E and 7F, the distance B90 between the third color light emitting area PXA-B and the sensing electrode SP2 in the plane may be set as a distance where the shielding efficiency due to the sensing electrode SP2 is not generated when looking at the third color light emitting area PXA-B from the third measurement point P3 and the fifth measurement point P5. Accordingly, an amount of the third color light L-B provided to the fifth measurement point P5 might not be reduced compared to that provided to the third measurement point P3. The third color light emitting area PXA-B might not exert influence on the color coordinate changes Δu' and Δv' measured at the fifth measurement point P5.

The expression, which is used with reference to FIGS. 5A and 5B, that the interference of the sensing electrode of the input sensor on the radiation path of the raw white image is negligible may mean that the shielding efficiency due to the sensing electrode SP2 is not generated in all of the first color light emitting area PXA-R, the second color light emitting area PXA-G, and the third color light emitting area PXA-B when looking at the first color light emitting area PXA-R, the second color light emitting area PXA-G, and the third color light emitting area PXA-B from each of the measurement points P1 to P5 (refer to FIG. 4A).

A distance T-B between the third color light emitting area PXA-B and the sensing electrode SP2 may be within a range from about 6 micrometers to about 25 micrometers. The distance B90 between the third color light emitting area PXA-B and the sensing electrode SP2 may vary depending on the distance T-B in the thickness direction. However, the distance B90 between the third color light emitting area PXA-B and the sensing electrode SP2 may be greater than the distance R90 of FIG. 7A and the distance G90 of FIG. 7C on the same condition.

In an embodiment, when the distance T-B between the third color light emitting area PXA-B and the sensing electrode SP2 in the thickness direction of the display device DD is about 13 micrometers and the distance B90 between the third color light emitting area PXA-B and the sensing electrode SP2 in the plane is about 11 micrometers, the shielding efficiency due to the sensing electrode SP2 might not be generated in the third color light emitting area PXA-B. Additionally, when looking at the third color light emitting area PXA-B from the measurement point with the azimuth angle of about 135° and the azimuth angle of about 60° with respect to the third color light emitting area PXA-B and the sensing electrode SP2 shown in FIG. 7E, the shielding efficiency due to the sensing electrode SP2 might not be generated in the third color light emitting area PXA-B.

FIG. 8 is a graph showing the color coordinate changes Δu' and Δv' of the display device including the first color, second color, and third color light emitting areas PXA-R, PXA-G, and PXA-B and the sensing electrode SP2 of FIGS. 7A to 7F according to an embodiment of the present disclosure. As shown by the graph of FIG. 8, the value of Δv' at the fifth measurement point P5 is greatly reduced when compared to that of the graph of FIG. 5A. According to the graph of FIG. 8, the user may become insensitive (or less sensitive) to the color coordinate changes Δu' and Δv' depending on the viewing angle since the white images measured at the third to fifth measurement points P3 to P5 have similar color impression.

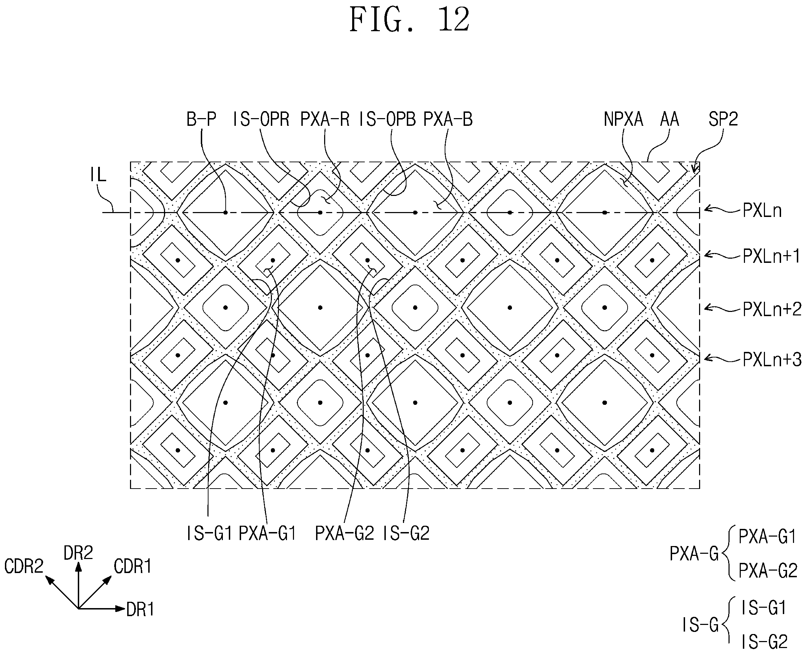

Different from the above description, in a case where the white image measured at the fifth measurement point P5 is the bluish white image compared to the white image perceived at the third measurement point P3 and the fourth measurement point P4, the sensing electrode SP2 may be designed such that the shielding efficiency or the partial shielding efficiency due to the sensing electrode SP2 is not generated with respect to the first color light emitting area PXA-R and the second color light emitting area PXA-G and the shielding efficiency or the partial shielding efficiency due to the sensing electrode SP2 is generated only with respect to the third color light emitting area PXA-B. The distance between the sensing electrode SP2 and the first color light emitting area PXA-R and the distance between the sensing electrode SP2 and the second color light emitting area PXA-G may be changed to the distance B90 of FIG. 7E, and the distance between the sensing electrode SP2 and the third color light emitting area PXA-B may be changed to the distance R90 of FIG. 7A. This will be described with reference to FIG. 12.

In addition, in a case where the white image measured at the fifth measurement point P5 is the magentish white image compared to the white image perceived at the third measurement point P3 and the fourth measurement point P4, the sensing electrode SP2 may be designed such that the shielding efficiency or the partial shielding efficiency due to the sensing electrode SP2 is generated with respect to the first color light emitting area PXA-R and the third color light emitting area PXA-B and the shielding efficiency or the partial shielding efficiency due to the sensing electrode SP2 is not generated only with respect to the second color light emitting area PXA-G. On the contrary, in a case where the white image measured at the fifth measurement point P5 is the greenish white image compared to the white image perceived at the third measurement point P3 and the fourth measurement point P4, the design of the sensing electrode SP2 may be changed such that the shielding efficiency or the partial shielding efficiency due to the sensing electrode SP2 is not generated with respect to the first color light emitting area PXA-R and the third color light emitting area PXA-B and the shielding efficiency or the partial shielding efficiency due to the sensing electrode SP2 is generated only with respect to the second color light emitting area PXA-G.

In addition, in a case where the white image measured at the fifth measurement point P5 is the cyanish white image compared to the white image perceived at the third measurement point P3 and the fourth measurement point P4, the sensing electrode

SP2 may be designed such that the shielding efficiency or the partial shielding efficiency due to the sensing electrode SP2 is generated with respect to the second color light emitting area PXA-G and the third color light emitting area PXA-B and the shielding efficiency or the partial shielding efficiency due to the sensing electrode SP2 is not generated only with respect to the first color light emitting area PXA-R. On the contrary, in a case where the white image measured at the fifth measurement point P5 is the reddish white image compared to the white image perceived at the third measurement point P3 and the fourth measurement point P4, the design of the sensing electrode SP2 may be changed such that the shielding efficiency or the partial shielding efficiency due to the sensing electrode SP2 is not generated with respect to the second color light emitting area PXA-G and the third color light emitting area PXA-B and the shielding efficiency or the partial shielding efficiency due to the sensing electrode SP2 is generated only with respect to the first color light emitting area PXA-R.

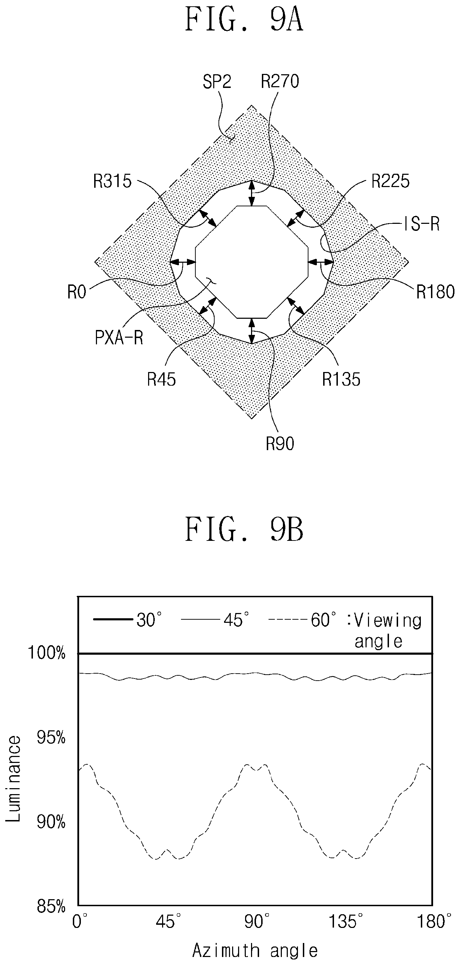

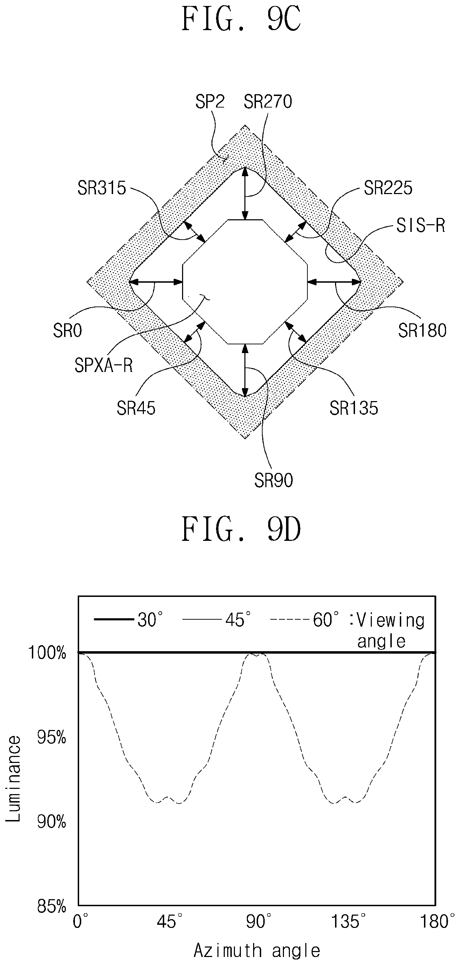

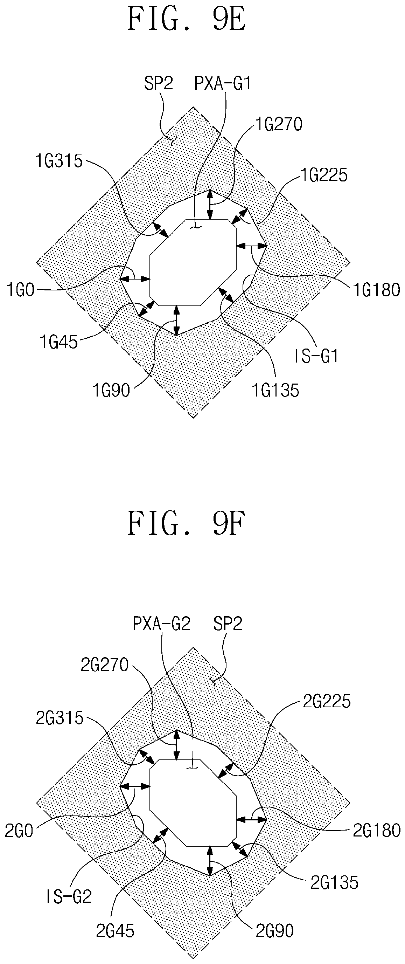

FIG. 9A is a plan view of the first color light emitting area PXA-R and the sensing electrode SP2 according to an embodiment of the present disclosure. FIG. 9B is a graph of variations in luminance ratio of the first color light as a function of the viewing angle and the azimuth angle according to an embodiment of the present disclosure. FIG. 9C is a plan view of a first color light emitting area and a sensing electrode according to a comparative example. FIG. 9D is a graph of variations in luminance ratio of the first color light as a function of the viewing angle and the azimuth angle according to a comparative example. FIG. 9E is a plan view of a first type second color light emitting area PXA-G1 and a sensing electrode SP2 according to an embodiment of the present disclosure. FIG. 9F is a plan view of a second type second color light emitting area PXA-G2 and a sensing electrode SP2 according to an embodiment of the present disclosure.

Referring to FIG. 9A, distances between the first color light emitting area PXA-R and the sensing electrode SP2, which are measured at eight points respectively having azimuth angles of about 0°, about 45°, about 90°, about 135°, about 180°, about 225°, about 270°, and about 315°, in a plane may be defined as a first distance R0, a second distance R45, a third distance R90, a fourth distance R135, a fifth distance R180, a sixth distance R225, a seventh distance R270, and an eighth distance R315, respectively.

In the description with reference to FIGS. 7A to 7F, the shielding efficiency of the sensing electrode SP2 is described on the basis of the third distance R90. However, the shielding efficiency of the sensing electrode SP2 described with reference to FIGS. 7A to 7F may be equally applied to the points having the azimuth angles different from that of the third distance R90.

Each of the first distance R0 to the eighth distance R315 between the first color light emitting area PXA-R and the sensing electrode SP2 may be smaller than a corresponding distance among the first distance to the eighth distance between the third color light emitting area PXA-B and the sensing electrode SP2. Each of the first distance to the eighth distance between the second color light emitting area PXA-G and the sensing electrode SP2 may be smaller than a corresponding distance among the first distance to the eighth distance between the third color light emitting area PXA-B and the sensing electrode SP2. In this case, the value of Δv' of the color coordinate changes Δu' and Δv' measured at each of the eight points respectively having the azimuth angles of about 0°, about 45°, about 90°, about 135°, about 180°, about 225°, about 270°, and about 315° and the viewing angle of about 60° may be reduced.

Referring to FIG. 9A, the first distance R0, the third distance R90, the fifth distance R180, and the seventh distance R270 may be the same as each other, and the second distance R45, the fourth distance R135, the sixth distance R225, and the eighth distance R315 may be the same as each other. The shielding efficiencies of the sensing electrode SP2, which respectively occur at four points having the viewing angle of about 60° and the azimuth angles of about 0°, about 90°, about 180°, and about 270°, e.g., the shielding areas of the first color light emitting area PXA-R due to the sensing electrode SP2 at the four points, may be the same as each other. The shielding efficiencies of the sensing electrode SP2, which respectively occur at four points having the viewing angle of about 60° and the azimuth angles of about 45°, about 135°, about 225°, and about 315°, e.g., the shielding areas of the first color light emitting area PXA-R due to the sensing electrode SP2 at the four points, may be the same as each other. However, the shielding area of the first color light emitting area PXA-R by the sensing electrode SP2, which is measured at the point having the viewing angle of about 60° and the azimuth angle of about 0°, may be different from the shielding area of the first color light emitting area PXA-R by the sensing electrode SP2, which is measured at the point having the viewing angle of about 60° and the azimuth angle of about 45°.

In an embodiment, the first color light emitting area PXA-R and the first opening IS-R may have different shapes from each other to satisfy the above-described condition. The first color light emitting area PXA-R or the light emitting opening PDL-OP (refer to FIG. 3B) corresponding to the first color light emitting area PXA-R may define a substantially N-sided polygon shape, and the first opening IS-R may define a substantially M-sided polygon shape, a circular shape, or an oval shape. In an embodiment, N is a natural number equal to or greater than 4, and M is a natural number greater than N.

FIG. 9A shows the first color light emitting area PXA-R having an octagon shape and the first opening IS-R having a dodecagon shape as a representative example. In the case where M is greater than N, a difference between the first distance R0, the second distance R45, the third distance R90, the fourth distance R135, the fifth distance R180, the sixth distance R225, the seventh distance R270, and the eighth distance R315 may be reduced.

The first distance R0, the third distance R90, the fifth distance R180, and the seventh distance R270 may be obtained by measuring separation distances between vertices of the first opening IS-R and sides of the first color light emitting area PXA-R when viewed in the plane. The second distance R45, the fourth distance R135, the sixth distance R225, and the eighth distance R315 may be obtained by measuring separation distances between sides of the first opening IS-R and sides of the first color light emitting area PXA-R when viewed in the plane.

The difference between the first distance R0, the second distance R45, the third distance R90, the fourth distance R135, the fifth distance R180, the sixth distance R225, the seventh distance R270, and the eighth distance R315 may be equal to or smaller than about 1.5 micrometers. In an embodiment, each of the first distance R0, the third distance R90, the fifth distance R180, and the seventh distance R270 may be within a range from about 4 micrometers to about 5 micrometers, and each of the second distance R45, the fourth distance R135, the sixth distance R225, and the eighth distance R315 may be within a range from about 5 micrometers to about 6 micrometers.

Referring to FIG. 9B, the luminance of the first color light measured at the viewing angle of about 45° may decrease compared to that measured at the viewing angle of about 30°, and the luminance of the first color light measured at the viewing angle of about 60° may decrease compared to that measured at the viewing angle of about 45°. A difference between luminances of the first color light, which are measured at five points having the viewing angle of about 60° and the azimuth angles of about 0°, about 45°, about 90°, about 135°, and about 180°, may be equal to or smaller than about 5%. When compared to the comparative example described below, the difference between luminances of the first color light is reduced by about 50%.

FIG. 9C shows a first color light emitting area SPXA-R and a first opening SIS-R according to a comparative example. According to the comparative example, the first color light emitting area SPXA-R may define a substantially K-sided polygon shape, and the first opening SIS-R may define a substantially L-sided polygon shape. In an embodiment, K is a natural number equal to or greater than 4, and L is a natural number equal to or smaller than K.

FIG. 9C shows the first color light emitting area SPXA-R having an octagon shape and the first opening SIS-R having a square shape as a representative example. In a case where L is smaller than K, a difference between a first distance SR0, a second distance SR45, a third distance SR90, a fourth distance SR135, a fifth distance SR180, a sixth distance SR225, a seventh distance SR270, and an eighth distance SR315 may relatively increase. In the comparative example, each of the first distance SR0, the third distance SR90, the fifth distance SR180, and the seventh distance SR270 may be about 7.5 micrometers, and each of the second distance SR45, the fourth distance SR135, the sixth distance SR225, and the eighth distance SR315 may be about 5.5 micrometers.

In FIG. 9D, a graph of a viewing angle of about 30° and a graph of a viewing angle of about 45° overlap each other and are shown as one graph. The luminance of the first color light, which is measured at the viewing angle of about 45°, does not decrease compared to that measured at the viewing angle of about 30°. However, the luminance of the first color light, which is measured at the viewing angle of about 60°, decreases compared to that measured at the viewing angle of about 45°. A difference between luminances of the first color light, which are measured at five points having the viewing angle of about 60° and the azimuth angles of about 0°, about 45°, about 90°, about 135°, and about 180° may be about 10%.

The arrangement (or the shape and the separation distance) of the third color light emitting area PXA-B and the sensing electrode SP2 shown in FIG. 7E may be similar to the arrangement of the first color light emitting area SPXA-R and the first opening SIS-R according to the comparative example. The third color light emitting area PXA-B shown in FIG. 7E may define the K-sided polygon shape, and the third opening IS-B may define the L-sided polygon shape a circular shape, or an oval shape. However, since the sensing electrode SP2 does not cause the shielding efficiency with respect to the third color light emitting area PXA-B at the viewing angle of about 60° as described with reference to FIG. 7E, the luminance difference described with reference to FIG. 9D might not occur between the third color light emitting area PXA-B and the sensing electrode SP2 shown in FIG. 7E.

In addition, the third color light emitting area PXA-B and the third opening IS-B may have different sizes but the same shape. Each of the third color light emitting area PXA-B and the third opening IS-B may have a substantially square shape, and vertices of the square shape of the third color light emitting area PXA-B may be disposed to correspond to vertices of the square shape of the third opening IS-B, respectively.

Contrary to the description with reference to FIGS. 7A to 7F, when the white image measured at the fifth measurement point P5 is the bluish white image compared to the white image perceived at the third measurement point P3 and the fourth measurement point P4, a design rule between the first color light emitting area PXA-R and the first opening IS-R described with reference to FIGS. 9A and 9B may be applied to a design rule between the third color light emitting area PXA-B and the third opening IS-B. In addition, a design rule between the first color light emitting area SPXA-R and the first opening SIS-R described with reference to FIGS. 9C and 9D according to the comparative example may be applied to a design rule between the first color light emitting area PXA-R and the first opening IS-R. In addition, the design rule between the first color light emitting area SPXA-R and the first opening SIS-R described with reference to FIGS. 9C and 9D according to the comparative example may be applied to a design rule between the second color light emitting area PXA-G and the second opening IS-G.

FIGS. 9E and 9F show the first type light emitting area PXA-G1 and the second type light emitting area PXA-G2, respectively. The first type light emitting area PXA-G1 and the first type opening IS-G1 may have different shapes from each other, and the second type light emitting area PXA-G2 and the second type opening IS-G2 may have different shapes from each other. Each of the first type light emitting area PXA-G1 and the second type light emitting area PXA-G2 may define a substantially I-sided polygon shape, and each of the first type opening IS-G1 and the second type opening IS-G2 may define a substantially J-sided polygon shape, a circular shape, or an oval shape. I may be a natural number equal to or greater than 4, and J may be a natural number greater than I.

Referring to FIG. 9E, a first distance 1G0, a third distance 1G90, a fifth distance 1G180, and a seventh distance 1G270 may be the same as each other, and a second distance 1G45, a fourth distance 1G135, a sixth distance 1G225, and an eighth distance 1G315 may be the same as each other. Each of the first distance 1G0, the third distance 1G90, the fifth distance 1G180, and the seventh distance 1G270 may be within a range from about 6.5 micrometers to about 7.3 micrometers, and each of the second distance 1G45, the fourth distance 1G135, the sixth distance 1G225, and the eighth distance 1G315 may be within a range from about 3 micrometers to about 4 micrometers.

The first distance 1G0, the second distance 1G45, the third distance 1G90, the fifth distance 1G180, the sixth distance 1G225, and the seventh distance R270 may be obtained by measuring separation distances between vertices of the first type opening IS-G1 and sides of the first type light emitting area PXA-G1 when viewed in a plane. The fourth distance 1G135 and the eighth distance 1G315 may be obtained by measuring separation distances between sides of the first type opening IS-G1 and sides of the first type light emitting area PXA-G1.

The second type light emitting area PXA-G2, which is symmetric to the first type light emitting area PXA-G1 with respect to an imaginary line connecting the azimuth angle of about 90° and the azimuth angle of about 270°, may be designed to have a design size that is opposite to a design size of the first type light emitting area PXA-G1 with respect to the sensing electrode SP2. The shielding efficiency of the sensing electrode SP2 with respect to the second color light emitting area PXA-G may be determined by an average of the shielding efficiency of the sensing electrode SP2 with respect to the first type light emitting area PXA-G1 and the second type light emitting area PXA-G2.

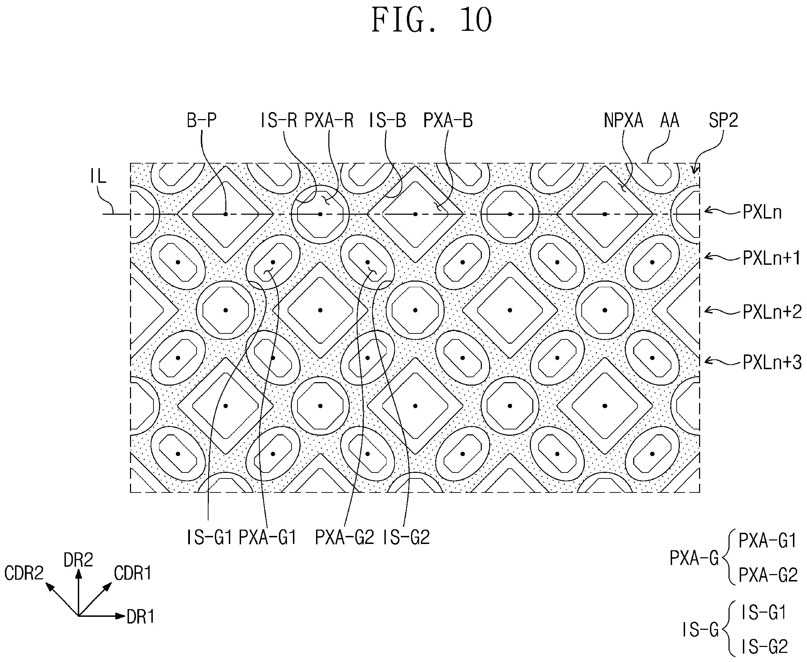

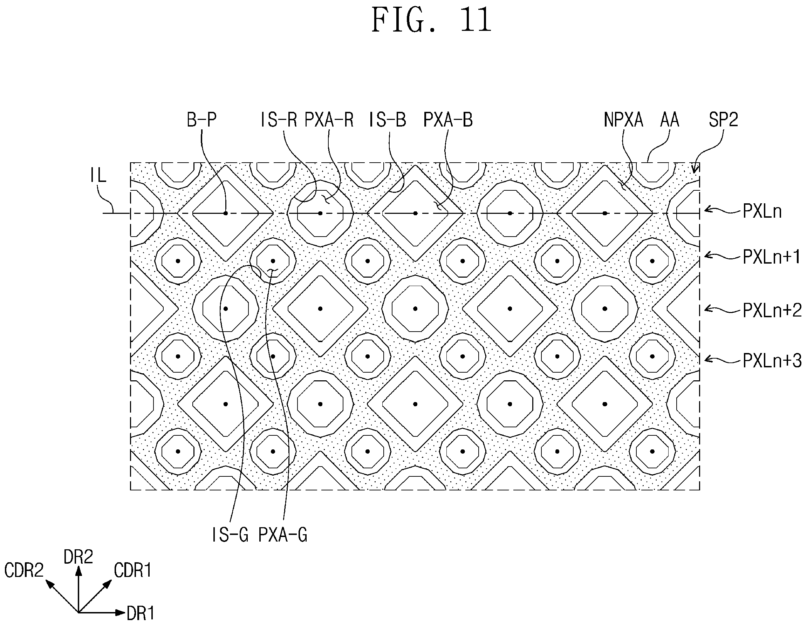

FIG. 10 is an enlarged plan view of a display device according to an embodiment of the present disclosure. FIG. 11 is an enlarged plan view of a display device according to an embodiment of the present disclosure. FIG. 12 is an enlarged plan view of a display device according to an embodiment of the present disclosure.

FIGS. 10 to 12 are plan views corresponding to that shown in FIG. 6. Hereinafter, for convenience of explanation, a further detailed description of elements and technical aspects previously described with reference to FIGS. 6 to 9F will be omitted.

Referring to FIG. 10, a first opening IS-R may have a circular shape. In addition, a second opening IS-G may have an oval shape. In addition, a third opening IS-B may have a substantially square shape. In an embodiment, a third color light emitting area PXA-B having the substantially square shape is shown as a representative example.

An embodiment as described herein shows the display device that is designed to correct a yellowish white image. As described with reference to FIGS. 7A to 9F, each of the first distance R0 to the eighth distance R315 between the first color light emitting area PXA-R and the sensing electrode SP2 may be smaller than the corresponding distance among the first distance to the eighth distance between the third color light emitting area PXA-B and the sensing electrode SP2. Each of the first distances 1G0 and 2G0 to the eighth distances 1G315 and 2G315 may be smaller than a corresponding distance among the first distance to the eighth distance between the third color light emitting area PXA-B and the sensing electrode SP2.

FIG. 11 shows a third opening IS-B having a substantially square shape and a third color light emitting area PXA-B having a substantially square shape as a representative example.

Referring to FIG. 11, second color light emitting areas PXA-G may be provided in one type. The second color light emitting areas PXA-G may have substantially the same shape as each other. Second openings IS-G may also have substantially the same shape as each other. A shielding efficiency of a sensing electrode SP2 with respect to the second color light emitting area PXA-G may occur equally in the second color light emitting areas PXA-G.

An embodiment as described herein shows the display device that is designed to correct a yellowish white image. Each of first to eighth distances between the second color light emitting area PXA-G and the sensing electrode SP2 may be smaller than a corresponding distance among first to eighth distances between the third color light emitting area PXA-B and the sensing electrode SP2. The second color light emitting area PXA-G may define a substantially I-sided polygon shape, and the second opening IS-G or the light emitting opening PDL-OP (refer to FIG. 3B) corresponding to the second color light emitting area PXA-G may define a substantially J-sided polygon shape, a circular shape, or an oval shape. I may be a natural number equal to or greater than 4, and J may be a natural number greater than I.

FIG. 12 shows the display device that is designed to correct a bluish white image when the bluish white image is measured at a fifth measurement point P5. A design of a sensing electrode SP2 is changed such that a shielding efficiency or a partial shielding efficiency by the sensing electrode SP2 might not occur with respect to a first color light emitting area PXA-R and a second color light emitting area PXA-G and the shielding efficiency or the shielding efficiency by the sensing electrode SP2 may occur only with respect to a third color light emitting area PXA-B.

A distance between the sensing electrode SP2 and the first color light emitting area PXA-R and a distance between the sensing electrode SP2 and the second color light emitting area PXA-G are changed to the distance B90 of FIG. 7E, and a distance between the sensing electrode SP2 and the third color light emitting area PXA-B is changed to the distance R90 of FIG. 7A. That is, each of first to eighth distances between the third color light emitting area PXA-B and the sensing electrode SP2 may be smaller than a corresponding distance among first to eighth distances between the first color light emitting area PXA-R and the sensing electrode SP2. In addition, each of the first to eighth distances between the third color light emitting area PXA-B and the sensing electrode SP2 may be smaller than a corresponding distance among first to eighth distances between the second color light emitting area PXA-G and the sensing electrode SP2.

The design rule described with reference to FIGS. 9A and 9B may be applied to a design rule between the sensing electrode SP2 and the third color light emitting area PXA-B. On the contrary, the design rule described with reference to FIGS. 9C and 9D may be applied to a design rule between the sensing electrode SP2 and the first color light emitting area PXA-R and a design rule between the sensing electrode SP2 and the second color light emitting area PXA-G.

While the present disclosure has been particularly shown and described with reference to embodiments thereof, it will be understood by those of ordinary skill in the art that various changes in form and detail may be made therein without departing from the scope of the present disclosure as defined by the following claims.

## Claims

1. A display device, comprising:
a base layer;
a pixel definition layer disposed on the base layer and comprising a first light emitting opening, a second light emitting opening, and a third light emitting opening, which are defined therethrough;
a first light emitting element comprising a first electrode providing a first color light emitting area exposed through the first light emitting opening;
a second light emitting element comprising a second electrode providing a second color light emitting area exposed through the second light emitting opening;
a third light emitting element comprising a third electrode providing a third color light emitting area exposed through the third light emitting opening;
a thin film encapsulation layer covering the first light emitting element, the second light emitting element, and the third light emitting element; and
a sensing electrode disposed on the thin film encapsulation layer and overlapping the pixel definition layer,
wherein a first opening corresponding to the first light emitting opening and having a size greater than a size of the first light emitting opening, a second opening corresponding to the second light emitting opening and having a size greater than a size of the second light emitting opening, and a third opening corresponding to the third light emitting opening and having a size greater than a size of the third light emitting opening are defined through the sensing electrode, and
the sensing electrode partially shields the first color light emitting area and the second color light emitting area or partially shields the third color light emitting area when the first color light emitting area, the second color light emitting area, and the third color light emitting area are viewed from a first point having a first viewing angle with respect to a normal line of the base layer.

2. The display device of claim 1, wherein the sensing electrode partially shields the first color light emitting area and the second color light emitting area, and about 5% to about 20% of the first color light emitting area is shielded by the sensing electrode when the first viewing angle is about 60°.

3. The display device of claim 2, wherein a distance between a plane defined by an upper surface of the first electrode and a plane defined by a lower surface of the sensing electrode is within a range from about 6 micrometers to about 25 micrometers.

4. The display device of claim 2 or claim 3, wherein a size of the first color light emitting area shielded by the sensing electrode when the first color light emitting area is viewed from a second point having a same viewing angle as the first point and an azimuth angle different from the first point is different from a size of the first color light emitting area shielded by the sensing electrode when the first color light emitting area is viewed from the first point.

5. The display device of any one of claims 1 to 4, wherein the sensing electrode partially shields the first color light emitting area and the second color light emitting area, and a size of the first color light emitting area shielded by the sensing electrode is different from a size of the second color light emitting area shielded by the sensing electrode.

6. The display device of claim 1, wherein the first color light emitting area and the second color light emitting area have different sizes and different shapes when viewed in a plane.

7. The display device of claim 6, wherein a size of the first color light emitting area shielded by the sensing electrode is about equal to a size of the second color light emitting area shielded by the sensing electrode.

8. The display device of claim 6 or claim 7, wherein a distance in the plane between the first color light emitting area and the sensing electrode, which is measured at an azimuth angle of the first point, is different from a distance between the second color light emitting area and the sensing electrode, which is measured at the azimuth angle of the first point.

9. The display device of any one of claims 1 to 8, wherein the first color light emitting area, the second color light emitting area, and the third color light emitting area are not shielded by the sensing electrode when the first color light emitting area, the second color light emitting area, and the third color light emitting area are viewed from a second point having a second viewing angle smaller than the first viewing angle.

10. The display device of claim 1, wherein
the sensing electrode partially shields the first color light emitting area and the second color light emitting area,
the first light emitting opening defines an N-sided polygon shape, and the first opening defines an M-sided polygon shape, a circular shape, or an oval shape,
N is a natural number equal to or greater than 4, and M is a natural number greater than N,
the second light emitting opening defines an I-sided polygon shape, and the second opening defines a J-sided polygon shape, a circular shape, or an oval shape, and
I is a natural number equal to or greater than 4, and J is a natural number greater than I, optionally wherein the third light emitting opening and the third opening define a K-sided polygon shape, K is a natural number equal to or greater than 4, and K is a natural number smaller than M and J.

11. The display device of claim 1, wherein
the sensing electrode partially shields the third color light emitting area,
the third color light emitting area defines a K-sided polygon shape, and the third opening defines an L-sided polygon shape, a circular shape, or an oval shape, and
K is a natural number equal to or greater than 4, and L is a natural number greater than K, optionally wherein the first light emitting opening and the first opening define an N-sided polygon shape, the second light emitting opening and the second opening define an I-sided polygon shape, I is a natural number, and N and I is a natural number smaller than L.

12. The display device of claim 1, wherein the sensing electrode partially shields the first color light emitting area and the second color light emitting area,
distances between the sensing electrode and each of the first color light emitting area and the third color light emitting area which are respectively measured at azimuth angles of about 0°, about 45°, about 90°, about 135°, about 180°, about 225°, about 270°, and about 315° are defined as a first distance, a second distance, a third distance, a fourth distance, a fifth distance, a sixth distance, a seventh distance, and an eighth distance, respectively, and
each of the first to eighth distances between the sensing electrode and the first color light emitting area is smaller than a corresponding distance among the first to eighth distances between the sensing electrode and the third color light emitting area.

13. The display device of claim 12, wherein a difference between the first to eighth distances between the sensing electrode and the first color light emitting area is smaller than a difference between the first to eighth distances between the sensing electrode and the third color light emitting area.

14. The display device of claim 12 or claim 13, wherein:
(i) a difference between the first to eighth distances between the sensing electrode and the first color light emitting area is equal to or smaller than about 1.5 micrometers; and/or
(ii) the second color light emitting area comprises a first type light emitting area and a second type light emitting area symmetrical with the first type light emitting area with respect to an imaginary line defined between the azimuth angle of about 90° and the azimuth angle of about 270°.

15. The display device of any one of claims 1 to 14, wherein the first light emitting element emits a red light, the second light emitting element emits a green light, and the third light emitting element emits a blue light.
